# EUROPEAN PATENT APPLICATION

(11) **EP 4 456 320 A1**
(43) Date of publication of application: **30.10.2024**
(21) Application number: 23216209.9
(22) Date of filing: 13.12.2023
(51) Int. Cl.: H01Q 1/22, H01Q 1/38, H01Q 1/48, H01Q 9/04, H01L 23/60, H01L 23/64, H01L 23/66

(54) **INTEGRATED MILLIMETER WAVE ANTENNA ESD PROTECTION**

(30) Priority: 25.04.2023 US 202318139204
(71) Applicant: INTEL Corporation, Santa Clara, CA 95054 (US)
(72) Inventor: GOSSNER, Harald, 85521 Riemerling (DE); WAGNER, Thomas, 91189 Regelsbach (DE); WAIDHAS, Bernd, 93186 Pettendorf (DE); SEIDEMANN, Georg, 84036 Landshut (DE); YANG, Tae Young, Portland, 97229 (US); KAMGAING, Telesphor, Chandler, 85249 (US)
(74) Representative: 2SPL Patentanwälte PartG mbB

(57) **Abstract**

An antenna device includes an antenna on a substrate, a low-impedance electrostatic discharge (ESD) path for an ESD pulse from the antenna to a ground terminal, and a signal path between the antenna and either a signal terminal or an integrated circuit (IC) die. The ESD and signal paths may each include separate vias through the substrate. A capacitor may couple a signal to or from the antenna and the signal terminal (or IC die) but block low-frequency power (such as an ESD pulse). The ESD path has an electrical length of a quarter of the wavelength and so may present a high impedance to ground for the signal. The antenna device may include or be coupled to an IC die. The IC die may couple to the signal and ground terminals, e.g., opposite the substrate from the antenna.

## Description

### BACKGROUND

Conventional electrostatic discharge (ESD) protection schemes for antennas and input/output (I/O) ports may use on-die ESD diodes to shunt ESD current to ground, but ESD diodes may be infeasible for protecting an antenna or signal I/O port due to high signal amplitudes. For example, an ESD diode protecting an integrated circuit (IC) terminal by clamping the terminal voltage to a certain maximum voltage (e.g., just above a supply voltage) and dissipating to ground any pulse that would otherwise exceed the voltage clamp would interfere with signals having amplitudes intended to exceed the supply voltage. Additionally, diodes are nonlinear devices that may cause signal distortions including, for example, intermodulation. Also, antenna and I/O ports at high signal frequencies (e.g., 100 GHz and above) are very sensitive to capacitive loads of, for example, ESD diodes. While ESD protection solutions for antennas may be implemented with inductor-capacitor (LC) filter networks and a local voltage clamping device between a coupling capacitor and an IC I/O port, parasitics of LC elements, as with diodes, may degrade high-frequency performance. An LC filter also requires additional components in-package or on-board, which can incur significant costs (e.g., of money and die or board area). Additional on-die area may be spent by implementation of the coupling cap in the IC and by any branch point from the signal line on, e.g., a silicon die to an ESD protection network. New materials, structures, or methods are needed to provide ESD protection for antenna ports while preserving signal strength and integrity.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements, e.g., with the same or similar functionality. The disclosure will be described with additional specificity and detail through use of the accompanying drawings:
FIG. 1 illustrates a cross-sectional profile view of an antenna device, including an antenna and an integrated circuit (IC) die on a substrate and a quarter-wavelength electrostatic discharge (ESD) path between the antenna and a ground terminal, in accordance with some embodiments;
FIGS. 2A and 2B illustrate cross-sectional profile and plan views of an antenna device, including an antenna, a ground terminal, and a coupling capacitor on a substrate and a quarter-wavelength ESD path between the antenna and a ground terminal, in accordance with some embodiments;
FIG. 3 illustrates cross-sectional profile and plan views of an antenna device, including an antenna, a ground terminal, and a coupling capacitor on a substrate and a quarter-wavelength ESD path between the antenna and a ground terminal, in accordance with some embodiments;
FIG. 4 illustrates cross-sectional profile and plan views of an antenna device, including an antenna and a ground terminal on a substrate and a quarter-wavelength ESD path between the antenna and a ground terminal, in accordance with some embodiments;
FIG. 5 is a flow chart of methods for forming an antenna device, including forming a quarter-wavelength ESD path between an antenna and a ground terminal, in accordance with some embodiments;
FIGS. 6A, 6B, 6C, and 6D illustrate schematic and cross-sectional profile views of an antenna device, including an antenna and polymer nanocomposite (PNC) devices, in accordance with some embodiments;
FIGS. 7A and 7B illustrate cross-sectional profile views of ESD and signal PNC devices, including concentrated electric field lines showing increased electric field intensities in ESD devices with enhanced electrode geometries, in accordance with some embodiments;
FIG. 8 illustrates a cross-sectional profile view of an antenna device, including PNC devices sharing a common layer of PNC between an IC die and a substrate, in accordance with some embodiments;
FIGS. 9A and 9B illustrate plan and cross-sectional profile views of an antenna device, including PNC deployed in a trench in substantially planar ESD and signal devices, in accordance with some embodiments;
FIGS. 10A, 10B, and 10C illustrate cross-sectional profile views of an antenna device, including PNC devices on the upper and lower surfaces of a substrate, in accordance with some embodiments;
FIG. 11 is a flow chart of methods for forming an antenna device, including forming PNC devices coupled to an antenna, in accordance with some embodiments;
FIG. 12 illustrates a diagram of an example data server machine employing an antenna device providing ESD protection and signal coupling, in accordance with some embodiments; and
FIG. 13 is a block diagram of an example computing device, in accordance with some embodiments.

### DETAILED DESCRIPTION

In the following detailed description, reference is made to the accompanying drawings that show, by way of illustration, specific embodiments in which the claimed subject matter may be practiced. These embodiments are described in sufficient detail to enable those skilled in the art to practice the subject matter. The various embodiments, although different, are not necessarily mutually exclusive. For example, a particular feature, structure, or characteristic described herein, in connection with one embodiment, may be implemented within other embodiments without departing from the spirit and scope of the claimed subject matter.

References within this specification to "one embodiment" or "an embodiment" mean that a particular feature, structure, or characteristic described in connection with the embodiment is included in at least one implementation encompassed within the present description. Therefore, the use of the phrase "one embodiment" or "in an embodiment" does not necessarily refer to the same embodiment. In addition, the location or arrangement of individual elements within each disclosed embodiment may be modified without departing from the spirit and scope of the claimed subject matter. The following detailed description is, therefore, not to be taken in a limiting sense, and the scope of the subject matter is defined only by the appended claims, appropriately interpreted, along with the full range of equivalents to which the appended claims are entitled.

The terms "over," "to," "between," and "on" as used herein may refer to a relative position of one layer with respect to other layers. One layer "over" or "on" another layer or bonded "to" another layer may be directly in contact with the other layer or may have one or more intervening layers. One layer "between" layers may be directly in contact with the layers or may have one or more intervening layers.

The terms "coupled" and "connected," along with their derivatives, may be used herein to describe structural relationships between components. These terms are not intended as synonyms for each other. Rather, in particular embodiments, "connected" may be used to indicate that two or more elements are in direct physical or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause and effect relationship, an electrical relationship, a functional relationship, etc.).

The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

The vertical orientation is in the z-direction and recitations of "top," "bottom," "above," and "below" refer to relative positions in the z-dimension with the usual meaning. However, embodiments are not necessarily limited to the orientations or configurations illustrated in the figure.

The terms "substantially," "close," "approximately," "near," and "about," generally refer to being within +/- 10% of a target value (unless specifically specified). Unless otherwise specified in the specific context of use, the term "predominantly" means more than 50%, or more than half. For example, a composition that is predominantly a first constituent means more than half of the composition is the first constituent. The term "primarily" means the most, or greatest, part. For example, a composition that is primarily a first constituent means the composition has more of the first constituent than any other constituent. A composition that is primarily first and second constituents means the composition has more of the first and second constituents than any other constituent.

Unless otherwise specified the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional," "profile," and "plan" correspond to orthogonal planes within a cartesian coordinate system. Thus, cross-sectional and profile views are taken in the x-z and y-z planes, and plan views are taken in the x-y plane. Typically, profile views in the x-z plane are cross-sectional views. Where appropriate, drawings are labeled with axes to indicate the orientation of the figure.

Materials, structures, and techniques are disclosed to improve the electrostatic discharge (ESD) protection of, and signal transmission between, antennas and radio frequency (RF) integrated circuits (ICs), e.g., RF front ends, while minimizing board and IC die area. Antenna ports can be exposed to severe ESD events, e.g., during operation and manufacture, so effective ESD protection shunting ESD current to electrical ground and limiting any consequent voltage transient at the RF input/output (I/O) port is essential. Typical ESD protection solutions, e.g., using ESD diodes, might degrade signals to or from an antenna, particularly at RF. ESD protection solutions, whether diodes or, for example, inductor-capacitor (LC) filter networks may also incur area and/or monetary costs.

ESD protection with superior RF and ESD performance in an antenna device can be implemented with a quarter-wavelength line on and through an insulating substrate, e.g., a glass interposer, carrying the antenna. This solution may conserve lateral area on a system board or IC die by implementation in an IC package over an IC die. The ESD path may be a direct-current (DC) short and very low ohmic path to ground at an ESD power spectrum of, e.g., 2 GHz and below, which may be meaningfully lower (and have a much longer wavelength) than the signal frequency of interest. The quarter-wavelength line can employ a via through the substrate, and the ESD path may include a microbump (or hybrid bond) coupling the substrate and IC die. Such an ESD path may provide very efficient ESD protection without additional cost and without limiting the performance of the antenna. A properly dimensioned, high-impedance approximation of an ideal quarter-wavelength line may maximize the RF performance of the antenna by forgoing the parasitics of an ESD diode and/or LC network. The electrodes of a coupling capacitor in an RF signal path may be formed of the backside metal of the insulating substrate and the frontside last metal of the IC die, which does not require any additional manufacturing steps. In some embodiments, a coupling capacitor is implemented on a surface of the insulating substrate.

Improved ESD performance can also be achieved in an antenna device having either or both of RF coupling or ESD protection devices employing a polymer nanocomposite (PNC) material. An integrated PNC device having a thin strip or layer of PNC on an insulating substrate or between the insulating substrate and an IC die may couple an RF signal or an ESD pulse from an antenna. By properly laying out the PNC device (e.g., with the proper geometry and dimensions), the PNC device may act as either a breakdown element during an ESD event or as a passive coupling capacitor in the RF signal path. For an ESD device, early breakdown is achieved by enhancing (e.g., focusing) the electric field at a given voltage by tip-like electrodes with small radii. Once triggered, a PNC ESD device may act as a conducting (e.g., very low ohmic) path to ground for ESD pulses and limit an ESD voltage, e.g., felt at a signal PNC device. The ohmic path may provide self-heating of the PNC, which may further reduce the voltage (e.g., a snapback) to below the trigger voltage. PNC coupling capacitors behave very linearly below the critical electric field of breakdown, which minimizes RF performance impact on high-frequency RF I/Os. A device with a thin layer of PNC may be integrated on a substrate in an IC package without the parasitics of a discrete surface-mounted device (SMD) and may improve the antenna device's ESD protection capabilities. The thickness and nanoparticle concentration of the device's PNC layer may be tuned to set a triggering field threshold at even low voltages, which may ensure satisfactory ESD protection.

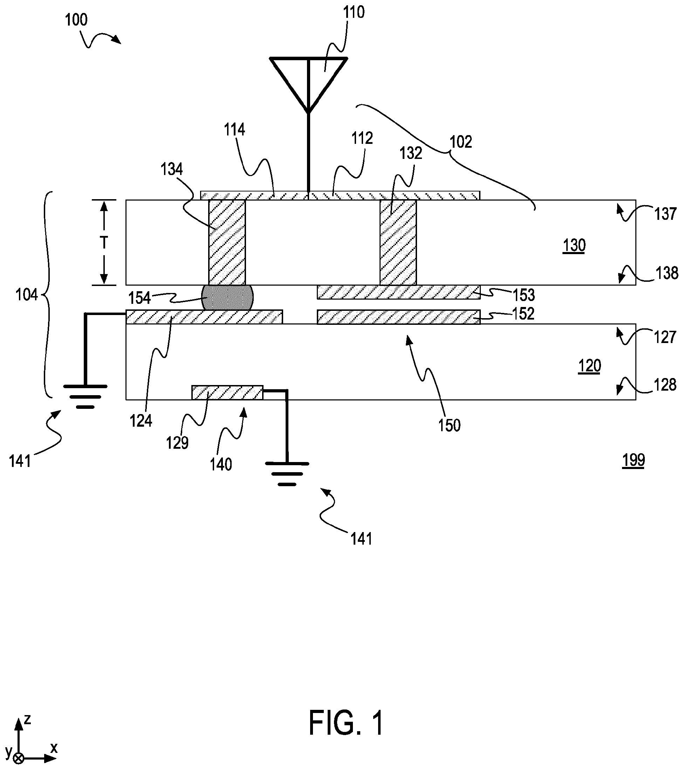

FIG. 1 illustrates a cross-sectional profile view of an antenna device 100, including an antenna 110 and an IC die 120 on a substrate 130 and a quarter-wavelength ESD path 104 between antenna 110 and a ground terminal 140, in accordance with some embodiments. Antenna device 100 includes substrate 130, antenna 110 on an upper surface 137 of substrate 130, IC die 120 on a lower surface 138 of substrate 130, and ground terminal 140 coupled to antenna 110, IC die 120, and an ESD via 134. Antenna 110 is coupled to ESD via 134 by ESD line 114 and to a signal via 132 by signal line 112. IC die 120 and substrate 130 are bonded together by solder, e.g., where microbump 154 joins upper interconnect interface 124 and via 134. IC die 120 is coupled to a host component 199, for example, at a lower surface 128 of IC die 120, including at a ground interconnect interface 129. Ground interconnect interface 129 on lower surface 128 may be coupled to a chassis or system ground through host component 199. Interconnect interfaces 124, 129 may be coupled by metallization structures (not shown), for example, a through-via (such as a through-silicon via (TSV)), within IC die 120.

Antenna 110 on surface 137 of substrate 130 is represented in FIG. 1 by a schematic symbol for an antenna, but antenna 110 may take any suitable form. For example, antenna 110 may be a microstrip antenna on upper surface 137 (e.g., substantially planar and horizontal on surface 137 in FIG. 1). Antenna 110 may include many such microstrip or patch antennas connected serially, e.g., to extend the bandwidth of antenna 110. Antenna 110 may include multiple microstrip or patch antennas stacked vertically, e.g., in multiple layers, on upper surface 137 of substrate 130. Antenna 110 may be configured to receive and/or transmit a signal, e.g., an RF signal. The RF signal may be a millimeter wave (mmWave) or extremely high frequency (EHF) signal, e.g., with a frequency in the tens or hundreds of GHz and a corresponding wavelength, for example, of less than 1 mm for a 300 GHz signal. The signal will have shorter and shorter wavelengths in dielectric materials (such as glass, silicon, etc., rather than in vacuum) with higher and higher permittivities, and a lower-frequency signal will have a correspondingly longer wavelength.

IC die 120 may be an RF front-end (or other RF IC) or any suitable IC with a signal terminal for coupling with antenna 110. For example, IC die 120 may include either or both of transmitter or receiver circuitry. IC die 120 may include any suitable material or materials. In some examples, IC die 120 may include monocrystalline silicon (including silicon on insulator (SOI)), polycrystalline silicon, germanium, silicon germanium, a III-V alloy material (e.g., gallium arsenide or gallium nitride), a silicon carbide (e.g., SiC), a sapphire (e.g., Al₂O₃), or any combination thereof. IC die 120 may also include semiconductor materials, metals, dielectrics, dopants, and other materials commonly found in IC dies. IC die 120 may include transistors, e.g., in one or more amplifiers to amplify the signal, such as a low-noise amplifier or power amplifier in a receiver or transmitter.

The signal may be conveyed to (or from) IC die 120 from (or to) antenna 110 through a signal path 102. Signal path 102 includes signal line 112, signal via 132, and coupling capacitor 150. IC die 120 is capacitively coupled to antenna 110 through signal via 132. Capacitor 150 is on surfaces 127, 138 between IC die 120 and substrate 130. Antenna device 100 and signal path 102 may advantageously couple a signal, and block DC voltages, between antenna 110 and IC die 120 with capacitor 150. Signal path 102 may be configured to pass or convey a signal of a certain wavelength (or frequency) or a band of wavelengths, for example, around or above a certain frequency. Signal path 102 may be so configured by proper dimensioning, e.g., of geometries of line 112, via 132, and/or capacitor 150. Higher frequencies, for example, RF, may allow for sufficiently small capacitors and for satisfactorily consistent coupling (and low serial impedance), even with normal manufacturing variations. Capacitor 150 may be configured to couple the signal as part of signal path 102 while still blocking all or substantially all of an ESD pulse (which may be of lower-frequency components than the signal) from IC die 120. Coupling capacitor 150 may be in the low pF range, e.g., approximately 1 pF. Coupling capacitor 150 is between, and includes portions of, substrate 130 and IC die 120. Coupling capacitor 150 includes a top electrode 153 and a bottom electrode 152, which are parallel capacitor plates configured to couple a signal between IC die 120 and antenna 110. IC die 120 includes bottom electrode 152, which may be coupled to an RF I/O internal to IC die 120. Substrate 130 includes top electrode 153. This parallel-plate structure may allow for a linear capacitance, for example, across a broad range of voltages and frequencies. This structure may allow for conservation of manufacturing steps; top electrode 153 may be formed concurrently with all conductive lines, pads, etc., on lower surface 138 of substrate 130, and bottom electrode 152 may be formed concurrently with all conductive lines, pads, etc. (e.g., interconnect interface 124), on top surface 127 of IC die 120. Bottom electrode 152 may have a similar structure to that of interconnect interface 124, which may be a bond pad. Bottom electrode 152 is capacitively coupled to antenna 110 through signal via 132. Coupling capacitor 150 may be implemented with air as a dielectric. In some embodiments, capacitor 150 includes a molding compound, underfill, or other material as a dielectric or spacer between electrodes 152, 153. In some such embodiments, antenna device 100 includes the molding compound or underfill material between surfaces 127, 138 and to either or both sides of capacitor 150. In some embodiments, IC die 120 includes a dielectric (e.g., an oxide, such as a silicon oxide, such as SiO₂) over bottom electrode 152. Top electrode 153 of substrate 130 and capacitor 150 is coupled to signal via 132 through substrate 130.

Substrate 130 is between antenna 110 and IC die 120 with antenna 110 and IC die 120 on opposite surfaces 137, 138 of substrate 130. Substrate 130 includes ESD via 134 and signal via 132 through substrate 130 and spanning between surfaces 137, 138. Substrate 130 is a planar platform of (or including) an insulator (or semiconductor). Substrate 130 may be an IC die coupled to IC die 120 and between antenna 110 and IC die 120. Substrate 130 may be an interposer, e.g., with horizontal electrical lines (such as lines 112, 114) on one or both of upper and lower surfaces 137, 138 coupled to vertical electrical lines (such as vias 132, 134) through substrate 130 and between surfaces 137, 138. Lines 112, 114 and vias 132, 134 may be conductive traces or other metallization structures (e.g., of copper or aluminum). Vias (such as vias 132, 134) may be tubular or cylindrical (e.g., hollow or solid) structures (or other shapes) of conductive material, including one or more metals, passing through at least a portion, e.g., through a layer or between surfaces, of a substrate. Other lines may be on or between surfaces 137, 138. In some embodiments, IC die 120 has an area greater than substrate 130. In some such embodiments, IC die 120 is coupled to multiple antennas 110. In some such embodiments, antenna device 100 includes multiple antennas 110. In some embodiments, substrate 130 has an area greater than IC die 120. In some such embodiments, substrate 130 is coupled to multiple IC dies 120. In some such embodiments, antenna device 100 includes multiple IC dies 120. In some embodiments, IC die 120 is coupled to a power supply and/or electrical ground 141 through substrate 130.

Substrate 130 may be of any sufficiently insulating material or materials. For example, substrate 130 may include one or more organic materials, such as a plastic. Substrate 130 may include silicon or glass. Glass or silicon may have advantages over, e.g., organic substrate materials: a coefficient of thermal expansion more closely matched to that of IC die 120, higher thermal conductivity, higher strength and stiffness, and a lower propensity for absorbing moisture. Glass additionally has a higher resistivity and lower cost than silicon. In some embodiments, substrate 130 is predominantly glass. The term "glass" refers to any non-crystalline (e.g., an amorphous) solid (without the long-range periodicity observed in a crystalline solid). A glass may be a compound, e.g., of silicon and one or more other elements (such as oxygen, boron, aluminum, etc., which may provide advantages, such as superior thermal, electrical, and/or mechanical properties). In some embodiments, substrate 130 includes a substantially monolithic layer of glass or silicon. In some such embodiments, vias 132, 134 are through-glass vias (TGV) through the layer of glass or TSV through the layer of silicon. In some embodiments, a conductive layer, or a layer with one or more conducting elements, is between substantially monolithic insulator (or semiconductor) layers. The conductor layer may serve, e.g., a routing or grounding function. The isotropy of a monolithic glass or silicon layer (or a layer at least substantially homogenous or continuous through a cross section of the layer) within substrate 130 may advantageously provide performance uniformity, e.g., relative to a fiberglass weave in an epoxy resin. Thus, unlike traditional printed circuit board (PCB) substrates, substrate 130 does not include a resin impregnated glass fiber or cloth core (e.g., commonly known as "PREPREG"). A layer of substantially continuous glass may include through-layer vias (or other discrete structures) while maintaining performance benefits, including uniformity, relative to a glass weave or other heterogenous structure.

Substrate 130 may employ inorganic materials in combination with organic materials or other inorganic materials. In some embodiments, substrate 130 includes a monolithic silicon or glass core between layers above and below, e.g., of organic material(s). For example, substrate 130 may include a glass layer or substrate accounting for 60% of a thickness T of substrate 130 between layers of a polymer-based material. Such cladding may provide sufficient mechanical flexibility and allow for differing thermal expansion coefficients between an insulating layer of, for example, glass in substrate 130 and the conducting vias 132, 134. Larger proportions of advantageous materials may provide more electrical insulation or otherwise improved performance, e.g., at high frequencies. Substrate 130 may include other materials, which may provide similar or other benefits. For example, sapphire has excellent electrical insulating properties and very high thermal conductivity. Sapphire and other familiar crystalline materials (such as silicon) may allow for very thin substrates 130. Substrate 130 may be of quartz or other ceramic materials. Substrate 130 may include composites, e.g., of a glass and crystalline ceramic material(s). Substrate 130 may include any suitable material, including semiconductor materials.

Ground terminal 140 of antenna device 100 is on lower surface 128 of IC die 120. Antenna 110 is coupled to ground terminal 140 by ESD path 104, which may be an electrical connection configured to convey an ESD pulse from antenna 110 to ground terminal 140 (and electrical ground 141). ESD path 104 is a ground path to ground terminal 140 and/or electrical ground 141. Electrical ground 141 is represented in FIG. 1 by a schematic symbol for ground, but this symbol only indicates a point in the system at zero potential (e.g., 0 V or reference ground) and through which an ESD pulse from antenna 110 may have a dissipation path; this ground symbol does not indicate additional wiring or electrical lines (e.g., connecting to interconnect interface 124 and IC die 120 from that side). An ESD pulse may be conveyed from antenna 110 to ground terminal 140 through ESD path 104 that includes ESD line 114, ESD via 134, microbump 154, and IC die 120 (including interconnect interfaces 124, 129). ESD path 104 with a sufficiently low impedance (e.g., much less than, a small fraction of, 1 Ω) and a sufficiently high maximum current density may dissipate to ground an ESD pulse of a few tens of amperes without damage or disruption of the signal structures coupled to antenna 110. For example, ESD path 104 may include multiple ESD vias 134 in parallel and provide a lower impedance and a higher maximum current. Multiple ESD vias 134 may connect to multiple ESD lines 114 (or multiple portions of a single ESD line 114). A larger-diameter ESD via 134 may also provide a lower impedance and a higher maximum current. Multiple ESD vias 134 with multiple diameters may provide flexibility, e.g., in matching impedances to ESD line(s) 114 and laying out ESD path 104 with sufficiently low impedance and sufficiently high maximum current density. ESD line 114 may be substantially wider than signal line 112, e.g., to accommodate a large ESD pulse.

IC die 120 includes interconnect interfaces 124, 129. Interconnect interface 124 is coupled to ESD via 134. In the example of FIG. 1, ESD via 134 and substrate 130 are soldered to interconnect interface 124, bonded at microbump 154. In some embodiments, substrate 130 includes an interconnect interface (e.g., in a same metal layer, and with a similar structure, as electrode 153) coupled to ESD via 134, and substrate 130 is soldered to interconnect interface 124 at that interconnect interface (on substrate 130), bonded at microbump 154. Microbump 154 may represent a solder ball or bump bonding IC die 120 and substrate 130, and microbump 154 may be substantially flatter than shown, e.g., only thick enough for a strong solder bond between IC die 120 and substrate 130. IC die 120 may include substantial metallization structures (not shown) to couple interconnect interfaces 124, 129 and to conduct an ESD pulse (as part of ESD path 104) from top surface 127 of IC die 120 to lower surface 128 of IC die 120 and host component 199. Ground terminal 140 of antenna device 100 may be electrically connected to electrical ground 141 through host component 199.

ESD path 104 has an electrical length (from antenna 110 to ground terminal 140) equal to a quarter of the wavelength of the signal. The signal wavelength may be much shorter than an ESD wavelength. ESD pulses generally have a low-frequency composition, e.g., relative to an RF signal, with the majority of power at or near DC (e.g., 0 Hz). This means that, although ESD path 104 may be a quarter of the wavelength of the signal, a typical ESD wavelength may be much longer than (e.g., hundreds of times the length of) ESD path 104. Consequently, ESD may have a very low impedance to ground (e.g., a virtual short), while a quarter-wavelength path for the signal may have a very high impedance to ground (e.g., approximating a perfect open). ESD path 104 may have an electrical length approximately equal to a quarter of the wavelength of the signal and still have a very high impedance at the signal wavelength. In some embodiments, ESD path 104 is 2% of the signal wavelength more or less than a quarter of the wavelength of the signal (e.g., 23% or 27% of the signal wavelength), and the impedance for the signal at the signal wavelength is at least multiple thousands of ohms. In some embodiments, ESD path 104 is one percent of the signal wavelength more or less than a quarter of the wavelength of the signal (e.g., 24% or 26% of the signal wavelength), and the impedance for the signal at the signal wavelength is greater than 10 kS2. As the signal wavelength may be within a wide range of lengths (e.g., depending on material(s) of substrate 130, signal frequency, etc.), so too may the length of ESD path 104 be within a wide range of lengths. For example, the signal wavelength may be multiple tens of millimeters or less than a millimeter. In some embodiments, the length of ESD path 104 is 3 mm or longer. Signals with higher frequencies may allow for shorter ESD paths 104. In some embodiments, the length of ESD path 104 is 1 mm or shorter. Substrates 130 with higher permittivities may allow for still shorter ESD paths 104. In some embodiments, the length of ESD path 104 is 500 µm, 100 µm, or shorter.

As ESD path 104 may include ESD via 134 (with a length equal to the thickness T of substrate 130), the length of quarter-wavelength ESD path 104 may limit thickness T of substrate 130, e.g., to 1 mm or less. Likewise, thickness T of substrate 130 may be adjusted (e.g., decreased) to adapt a layout or design for a different (e.g., higher) frequency. A thinner substrate 130 may also have advantages relative to a thicker substrate 130. A thinner substrate 130 may allow for a longer lateral portion of ESD path 104, which may enable additional layout options, e.g., to include multiple antennas 110. In some embodiments, thickness T of substrate 130 is 500 µm or less. Some applications, e.g., mobile handset or other applications with limited space considerations, may benefit from a yet-thinner substrate 130. In some embodiments, thickness T of substrate 130 is 100 µm or less. In some embodiments, substrate 130 is predominantly glass and includes a glass layer with thickness T of 100 µm or less. Some materials, e.g., sapphire or silicon, may allow for a thinner substrate 130. In some embodiments, thickness T of substrate 130 is 10 µm or less.

Multiple antennas 110 on substrate 130 may have separate ESD paths 104 and signal paths 102 (coupling antennas 110 to the same or separate IC dies 120). In some embodiments with multiple antennas 110 on substrate 130, antennas 110 are each configured for signals with separate frequencies, antennas 110 each have separate signal wavelengths, and each have separate quarter-wavelength ESD paths 104. In some embodiments with multiple antennas 110 on substrate 130, antennas 110 are configured for signals within a single bandwidth of a frequency spectrum, and antennas 110 share a quarter-wavelength ESD path 104, e.g., of an electrical length equal to a quarter-wavelength for a signal at the center of the bandwidth. In some such embodiments, the bandwidth is sufficiently narrow such that the quarter-wavelength ESD path 104 sufficiently approximates a quarter of a wavelength (and the impedance of quarter-wavelength ESD path 104 is sufficiently high for the signal) at the edges of the bandwidth.

In some embodiments, IC die 120 is coupled to a power supply (not shown) through a host component 199 coupled to a lower surface 128 of IC die 120. Besides interconnect interface 129, IC die 120 and host component 199 may be coupled by multiple other interconnect interfaces (not shown) on lower surface 128. The power supply may be a battery, voltage regulator, etc., or an electrical connection to such a supply. IC die 120 may be powered through host component 199 or substrate 130 (which may have a greater area than that of IC die 120 and may be coupled to multiple IC die 120) or by some other structure. Host component 199 may be a planar platform and may include dielectric and metallization structures. Host component 199 may mechanically support, and electrically couple to, IC die 120. At least one side of host component 199 includes interconnect interfaces, e.g., for soldering or direct bonding to one or more IC dies 120. The opposite side of host component 199 may include similar interfaces or, e.g., copper pads for socketing or solder bumps for bonding to another host component, for example, a printed circuit board. Host component 199 may be any platform with interconnect interfaces, such as a package substrate or interposer, another IC die, etc. Host component 199 may itself be a die or an insulating substrate. Host component 199 may bond to any platform, such as a package substrate or interposer, another IC die, etc. In some embodiments, antenna device 100 includes IC die 120 and host component 199.

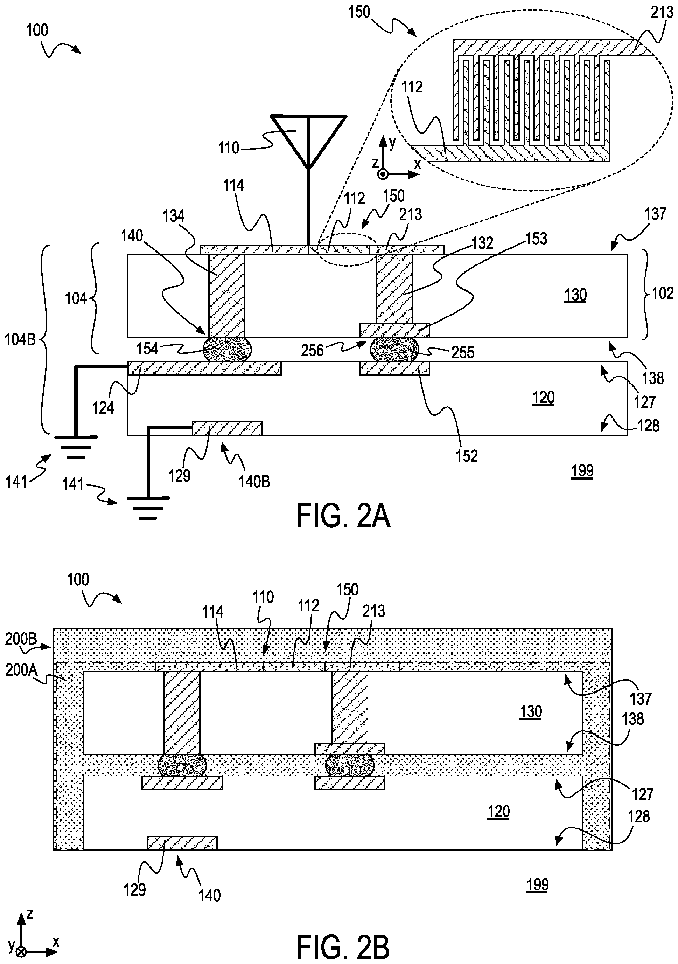

FIGS. 2A and 2B illustrate cross-sectional profile and plan views of antenna device 100, including antenna 110, ground terminal 140, and coupling capacitor 150 on substrate 130 and quarter-wavelength ESD path 104 between antenna 110 and ground terminal 140, in accordance with some embodiments. FIG. 2A shows antenna device 100 with single-layer capacitor 150. Coupling capacitor 150 is on upper surface 137 of substrate 130. IC die 120 and substrate 130 are bonded together, including by solder, e.g., where interconnect interface 124 and via 134 are coupled at microbump 154 and electrodes 152, 153 are coupled at microbump 255.

In the example of FIG. 2A, coupling capacitor 150 is an interdigitated capacitor (as seen in the magnified overhead/plan view) with signal lines 112, 213 as a pair of interdigitated electrodes in a same metal layer. A dielectric (e.g., air or a dielectric film over upper surface 137 of substrate 130) is between electrode lines 112, 213. This structure may allow for a compact capacitor 150 in a single metal layer on upper surface 137 of substrate 130 to block DC voltages, but couple a signal, between antenna 110 and IC die 120. This structure may also allow for electrode lines 112, 213 to be formed concurrently with other lines on surface 137 of substrate 130, which may be an interposer with electrical lines on both surfaces 137, 138. Although the plan view shows a simple layout of capacitor 150 with (e.g., transmission-line) portions of lines 112, 213 as orthogonally intersecting interdigitated portions of capacitor 150 for ease of illustration, lines 112, 213 may be laid out where interdigitated portions of capacitor 150 are substantially equidistant from corresponding transmission-line portions of lines 112, 213. In some embodiments, capacitor 150 is a parallel-plate capacitor, for example, with electrode lines 112, 213 in multiple layers on 137 with a dielectric layer (e.g., of air or a dielectric film) between electrode lines 112, 213.

IC die 120 and substrate 130 are bonded together, at least by solder. IC die 120 may include substantial metallization structures (not shown) to extend a robust electrical ground 141 to interconnect interface 124 and top surface 127 of IC die 120, e.g., from lower surface 128 of IC die 120 and host component 199. In some embodiments, antenna device 100 is coupled to IC die 120, and ESD path 104 from antenna 110 to ground terminal 140 includes ESD line 114 and ESD via 134. For example, microbump 154 may be on IC die 120 (at interconnect interface 124), and antenna device 100 may be coupled to IC die 120 by the solder between ground terminal 140 (at ESD via 134 and surface 138) and interconnect interface 124. In other embodiments, microbump 154 is on substrate 130 (and ESD via 134), and ESD path 104 from antenna 110 to ground terminal 140 (e.g., at microbump 154) also includes microbump 154. In some embodiments, for example, in which antenna device 100 does not include additional IC die 120, antenna device 100 and signal path 102 may have a signal terminal 256 available for coupling a signal to/from antenna 110, e.g., to an RF I/O of another device, such as an IC die. Signal terminal 256 may be a conductor and may be an interconnect interface. In some embodiments, electrode 153 is such a signal terminal 256 for antenna device 100. In some embodiments, microbump 255 is on substrate 130, and microbump 255 is signal terminal 256 for antenna device 100. In some embodiments, antenna device 100 includes IC die 120. In some such embodiments, ESD path 104B from antenna 110 to ground terminal 140B includes ESD line 114, ESD via 134, microbump 154, and IC die 120 (including interconnect interfaces 124, 129).

FIG. 2B illustrates antenna device 100, including IC die 120 coupled to substrate 130, encapsulated in a package dielectric 200B. Package dielectric 200A, 200B may be any suitable material. In some embodiments, package dielectric 200A, 200B includes an organic material, such as a mold compound or other polymer. In some embodiments, package dielectric 200A, 200B includes an inorganic material, such as an oxide (e.g., silicon dioxide) or other ceramic material. Though shown between substrate 130 and IC die 120 (and surfaces 127, 138), substrate 130 and IC die 120 are in contact (without a gap for package dielectric 200B) along the length of coplanar surfaces 127, 138 in some embodiments. Antenna device 100 is coupled to a power supply (not shown) through host component 199 by an interconnect interface (not shown). Antenna device 100 is coupled at ground terminal 140 to a system electrical ground through host component 199 by interconnect interface 129. Package dielectric 200B is over upper surface 137 of substrate 130 (including lines 112, 114, 213, capacitor 150, and planar antenna 110), over host component 199, and around substrate 130 and IC die 120 on all sides. In some embodiments, antenna device 100 is encapsulated in a package dielectric 200A, which is over host component 199 and around substrate 130 and IC die 120, but is flush with antenna 110 and lines 112, 114, 213 over substrate 130. The lower upper surface of package dielectric 200A may allow for coupling to a structure above antenna device 100, e.g., to couple to another antenna structure.

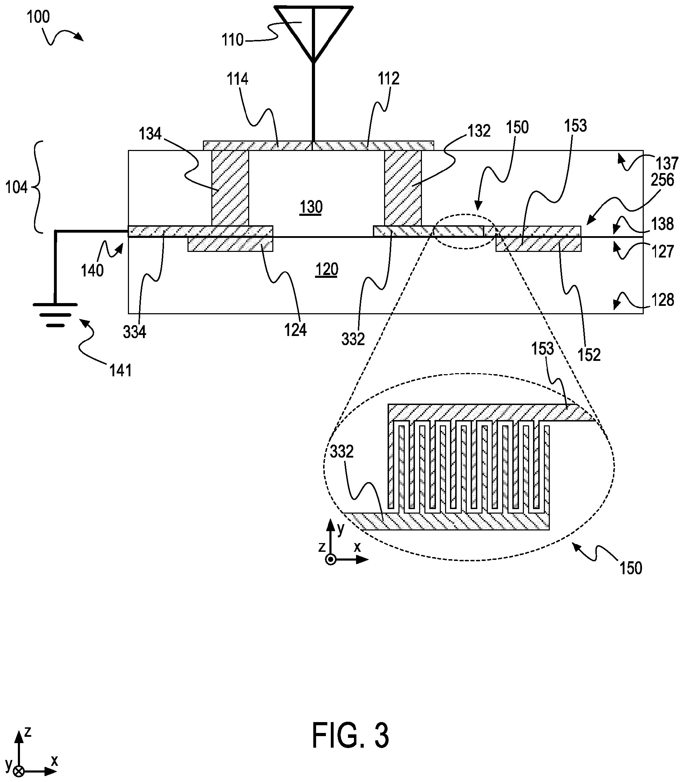

FIG. 3 illustrates cross-sectional profile and plan views of antenna device 100, including antenna 110, ground terminal 140, and coupling capacitor 150 on substrate 130 and quarter-wavelength ESD path 104 between antenna 110 and ground terminal 140, in accordance with some embodiments. Substrate 130 (and antenna device 100) are direct bonded to IC die 120. Substrate 130 includes ESD line 334, signal line 332, and electrode 153 in a single metal layer on lower surface 138 of substrate 130. ESD line 334 includes an interconnect interface coupled to interconnect interface 124 of IC die 120. Ground terminal 140 is on substrate 130 at ESD line 334, between substrate 130 and IC die 120. Signal terminal 256 is on substrate 130 at electrode 153, between substrate 130 and IC die 120.

Coupling capacitor 150 is on lower surface 138 of substrate 130. Coupling capacitor 150 is an interdigitated capacitor, as seen in the magnified plan view. Electrode 153 and signal line 332 are a pair of interdigitated, substantially coplanar electrodes on either side of a dielectric (e.g., air or a dielectric film over lower surface 138). This structure may allow for layout flexibility, e.g., where electrode 153 is offset from signal via 132. In some embodiments, capacitor 150 is substantially planar and between substrate 130 and IC die 120, but on upper surface 127 of IC die 120. Capacitor 150 may also be a multi-layer capacitor between substrate 130 and IC die 120 on (and below) either of surfaces 127, 138.

IC die 120 and substrate 130 are direct bonded. For example, metallization features on abutting surfaces 127, 138 may be metallurgically interdiffused (e.g., electrode 152 with electrode 153 and ESD line 334 with interconnect interface 124). In some embodiments, IC die 120 and substrate 130 are hybrid bonded. In some such embodiments, insulator (e.g., dielectric) material on lower surface 138 and between lines 332, 334 is chemically bonded to insulator material on upper surface 127 between interconnect interface 124 and electrode 152 (e.g., via Si-O-Si condensation bonds).

ESD path 104 includes ESD line 334 on lower surface 138 of substrate 130. Ground terminal 140 includes ESD line 334. IC die 120 is coupled to ground through ESD line 334 and ground terminal 140. In some embodiments, substrate 130 is a host component for IC die 120, and IC die 120 is coupled to a power supply through interconnect interfaces (not shown) on surfaces 127, 138. In some such embodiments, antenna device 100 includes IC die 120. IC die 120 and substrate 130 may be configured in other arrangements.

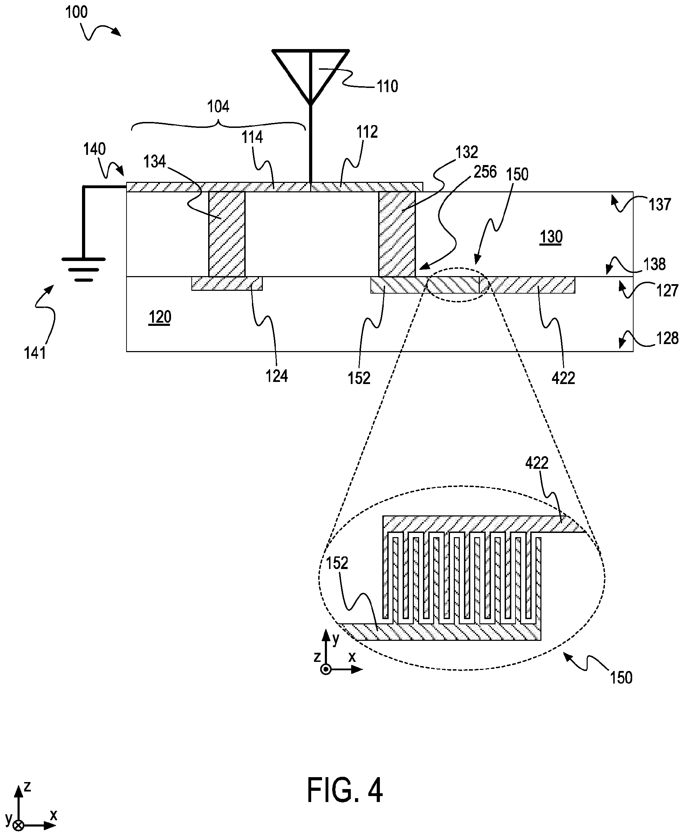

FIG. 4 illustrates cross-sectional profile and plan views of antenna device 100, including antenna 110 and ground terminal 140 on substrate 130 and quarter-wavelength ESD path 104 between antenna 110 and ground terminal 140, in accordance with some embodiments. Antenna 110 and antenna device 100 are coupled to electrical ground 141 by ESD path 104 on upper surface 137 of substrate 130. IC die 120 and substrate 130 are direct bonded. Coupling capacitor 150 is on upper surface 127 of IC die 120.

ESD path 104 includes at least ESD line 114 on upper surface 137 of substrate 130. ESD line 114 may be coupled to electrical ground 141 through (ground terminal 140 and), e.g., a host component coupled to surface 137. IC die 120 is coupled to ESD line 114 and electrical ground 141 through ESD via 134 and interconnect interface 124. Ground terminal 140 includes ESD line 114.

IC die 120 and substrate 130 are direct bonded. Via 134 may be direct bonded to (for example, metallurgically interdiffused with) interconnect interface 124, and via 132 may be direct bonded to electrode 152. In some embodiments, IC die 120 and substrate 130 are hybrid bonded. In some such embodiments, insulator material on lower surface 138 and between vias 132, 134 is chemically bonded to insulator material on upper surface 127 between interconnect interface 124 and electrode 152. In some embodiments, substrate 130 is a host component for IC die 120, and IC die 120 is coupled to a power supply through interconnect interfaces (not shown) on surfaces 127, 138.

IC die 120 includes capacitor 150. Capacitor 150, as seen in the magnified plan view, includes interdigitated, substantially coplanar electrodes 152, 422 on either side of a dielectric on upper surface 127. Capacitor 150 may be implemented as a multi-layer (e.g., metal-insulator-metal (MIM)) capacitor using multiple metal layers of substrate 130 or IC die 120.

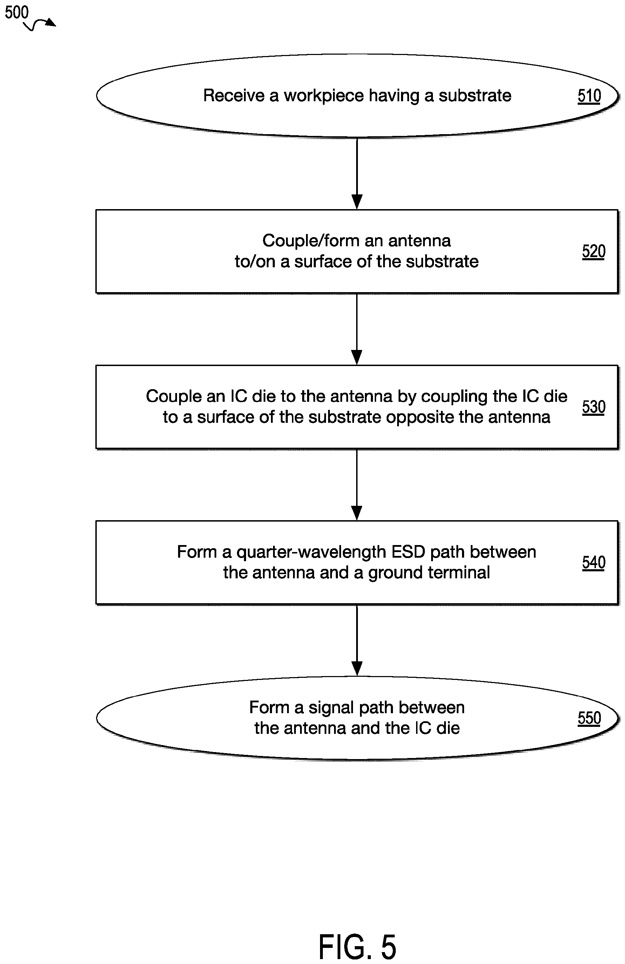

FIG. 5 is a flow chart of methods for forming an antenna device, including forming a quarter-wavelength ESD path between an antenna and a ground terminal, in accordance with some embodiments. Methods 500 include operations 510-550. Some operations shown in FIG. 5 are optional. Additional operations may be included. FIG. 5 shows an example sequence, but the operations can be done in other orders as well, and some operations may be omitted. Some operations can also be performed multiple times before other operations are performed. For example, multiple antennas may be coupled to the substrate. Some operations may be included within other operations so that the number of operations illustrated FIG. 5 is not a limitation of the methods 500.

Methods 500 at operation 510 where a workpiece, including a substrate, is received. Other structures may be received, including an antenna. In some embodiments, parts or materials for the received structures are received, and the structures may be further formed with the parts or materials. For example, metal may be received for forming components of the substrate, e.g., electrical lines, including through vias, and an antenna.

The substrate may be substantially as previously described, for example, at FIG. 1, or in some state of partial manufacture, e.g., not yet with all of the eventual metallization structures. For example, the substrate may be a planar platform of any sufficiently insulating material or materials, including an insulator or semiconductor material. The substrate may include one or more organic materials, such as a plastic. The substrate may include silicon, glass, or other insulator or semiconductor material, e.g., a sapphire. The substrate may be an IC die. In some embodiments, the substrate includes a monolithic silicon or glass core between layers above and below, e.g., of organic material(s). The received substrate may include electrical lines on one or more surfaces and/or electrical lines through the substrate and between the surfaces, e.g., plated (or solid filled) through vias.

At optional operation 520, an antenna may be coupled to the substrate, or an antenna may be formed on the substrate. In some embodiments, the antenna is received and coupled to the substrate, e.g., on an upper surface of the substrate. The antenna and substrate may be coupled by any suitable means. In some embodiments, the antenna is soldered or otherwise bonded to the substrate, for example, with an adhesive. In some embodiments, the antenna is direct bonded to metallization structures on the substrate.

The antenna may be formed by any suitable means. In some embodiments, the substrate is an interposer or similar substrate (e.g., with electrical lines at least on and between upper and lower surfaces), and the antenna is formed on a surface of the interposer concurrently with conductive traces. For example, metal may be deposited on the surface, or may be plated on and etched off, e.g., using conventional patterning and/or lithography techniques, to form a planar, microstrip antenna, such as a patch antenna. The antenna may be formed as, or part of, a substantially planar array of antennas on a surface of the substrate. In some embodiments, the antenna may be formed in one of multiple layers of planar antennas over the surface. The antenna has other suitable, both planar and nonplanar, structures in other embodiments.

The antenna is configured for the signal of interest, e.g., having the wavelength (or frequency) of interest. The antenna may be configured for (e.g., to transmit and/or to receive) the desired wavelength, e.g., by sizing, shaping, and coupling the antenna appropriately. For example, a patch antenna might be approximately (e.g., slightly shorter than) a half-wavelength wide and be coupled to a signal line at a center of the half-wavelength width. In some embodiments, the antenna is a quarter-wave monopole antenna or a modification thereof, e.g., a planar inverted-F antenna. The antenna configuration for the desired wavelength may include properly spacing the antenna away from any, e.g., parallel ground plane, including accounting for a given dielectric (permittivity) between antenna and ground. Multiple antennas may be formed (or coupled) to extend a bandwidth of the device, but such bandwidth extensions may introduce grounding, routing, or other issues. For example, two antennas with sufficiently distinct wavelengths may require separate ESD paths to ground and signal paths to, e.g., a signal terminal or IC die.

An IC die is coupled to a surface of the substrate at operation 530. In some embodiments, the antenna device includes the IC die. In some such embodiments, the IC die is coupled to the substrate on a surface opposite the antenna, which couples the IC die to the antenna. For example, the IC die may be soldered or direct bonded to the substrate. In some such embodiments, solder (e.g., microbumps) may be applied to metallization structures (e.g., vias or bond pads) on a surface of the substrate or IC die to be coupled, and the aligned and joined structure may be bonded at temperature. In some embodiments, the IC die may be direct bonded, including hybrid bonded. Direct bonding of the substrate and IC die may be at least metal-to-metal, for example, during which metallization structures sinter. In some embodiments, a hybrid bond is formed between both metallization features (e.g., by metal interdiffusion) and between dielectric materials (e.g., by Si-O-Si condensation bonds). Direct bonding may allow for finer pitch features of the substrate and IC die and for coupling the substrate and die at lower temperatures. For example, thermo-compression bonding may be at low temperatures (e.g., with sintering below the melting temperature(s) of the interconnects). Direct bonding at room temperature (e.g., with compression only) is also possible. Bonding finer pitch features (for example, finer than practicable by soldering) may require correspondingly more precise alignment before bonding. Direct bonding, particularly at lower temperatures, may benefit from pre-processing, for example, a plasma clean, to activate one or more surfaces for bonding. Selective heating (e.g., as an anneal) may be employed to strengthen a bond (e.g., by interdiffusion between pads). The selective heating may employ a laser or other means to localize heating to a specific region or structure (e.g. the IC die).

In some embodiments, the antenna device may be configured to be coupled to an IC die, for example, as part of a later assembly operation. In some such embodiments, the antenna device may be configured to be coupled to the IC die at a signal terminal and/or a ground terminal. In embodiments including an IC die, coupling the IC die and the substrate (e.g., at a surface of the substrate opposite the antenna) may include forming an ESD path between the antenna and a ground terminal and/or forming a signal path between the antenna and an IC die. For example, the IC die may include a portion of the ESD path to ground, and coupling the IC die to a substrate surface opposite the antenna and its substrate surface may couple the antenna to an ESD ground terminal on a surface of the IC die opposite the antenna, e.g., at a host component.

A quarter-wavelength ESD path is formed between the antenna and a ground terminal at operation 540. At sufficiently high signal frequencies, the ESD path has significantly different impedances to a signal and an ESD pulse. The impedance of an ESD path having a length a quarter of a signal wavelength is sufficiently high (e.g., approximating a perfect open) for the signal, while the ESD path impedance is sufficiently low (e.g., a DC short) for an ESD pulse. Although near-field (or lumped-element) circuit theory may model the ESD path as a DC short for an ESD pulse, transmission-line theory may be consulted for the signal response to the ESD path. For example, potential impedance discontinuities, such as a junction of a microstrip line and a through via, may advantageously be avoided or minimized. Accordingly, conductor (e.g., microstrip and via) and insulator (e.g., substrate) dimensions may considered to properly match impedances of adjoining portions of the ESD path. Besides dimensions, other materials characteristics (such as an insulator's permittivity or dielectric constant) may be considered.

The ESD path may be formed by and of any suitable means and materials. In some embodiments, at least a portion of the ESD path is formed concurrently with the antenna. For example, the antenna and at least a portion of the ESD path may be on an upper surface of the substrate, and the ESD path may be formed as described in the antenna discussion at operation 520. In some embodiments, at least some of the ESD path is on the substrate as received.

Forming the ESD path may also include forming a via through the substrate. For example, the ESD path may couple an antenna on an upper surface of the substrate to a ground terminal on, or coupled to, a lower surface of the substrate. A via may be formed by etching, boring, etc., a hole through the substrate (or through a layer of the substrate) and by depositing a conductor in the hole. In some embodiments, a hole is bored through the substrate, and an inner surface of the hole is plated with a metal. In some embodiments, a hole is etched through the substrate, and a metal is filled into the hole. A hole may be wet etched or by a dry etch technique, such as a reactive ion etch (RIE). A conductive material, such as a liner metal, may be isotropically deposited on an inner surface of the hole. A conductive material, such as a fill metal, may be deposited in the hole, e.g., over a liner material. Forming the ESD path may include forming multiple vias, e.g., to provide a low enough impedance and sufficient current-carrying capability to dissipate a large ESD path to ground without damage or other interference of the signal path. Advantageously, transmission line dimensions, for example, of parallel electrical paths, may be coordinated (e.g., equaled or at least approximated), and junctions between adjoining portions of the ESD path (e.g., at intersections of electrically parallel branches) may be matched.

At operation 550, a signal path is formed to and/or from the antenna. The signal path may convey a signal, e.g., an RF signal, to and/or from the antenna. For example, the signal path may be between the antenna and an RF front-end, an RF transmitter, or both (e.g., a transceiver with both transmitter and receiver circuitry). In some embodiments, the signal path is between the antenna and an IC die, e.g., an RF IC. In some such embodiments, the IC die is on a surface of the substrate opposite the antenna. In some embodiments, the signal path is between the antenna and a signal terminal. The signal terminal may be configured to be coupled to an IC die and may be on a surface of the substrate opposite the antenna.

The signal path may block DC voltages (and ESD energy) from passing between the antenna and an IC die (or signal terminal), for example, with a capacitor. The capacitor may couple higher frequency energy (e.g., an RF signal) while impeding lower frequency energy (e.g., DC or an ESD pulse). The capacitor may be formed as part of the signal path by any suitable means. In some embodiments, the capacitor is formed in a single metal layer, for example, as an interdigitated capacitor on a surface of the substrate. A single-layer capacitor may be formed on either side of the substrate (e.g., on the same surface as the antenna or opposite the antenna) or on an IC die. Such a capacitor may be formed in a similar manner as an antenna or electrical line on a substrate surface, for example, as microstrip lines, e.g., using conventional patterning and/or lithography techniques. In some embodiments, the capacitor is formed by placing parallel conductive surfaces across a dielectric from each other, e.g., as part of coupling the IC die and the substrate. For example, an electrode on a lower surface of the substrate may be positioned over an electrode on an upper surface of an IC die. In some such embodiments, the capacitor is formed by coupling the IC die and the substrate (e.g., at a surface of the substrate opposite the antenna). The dielectric between the electrodes may be air, e.g., by forming the electrodes as plates (such as pads) recessed back from one or both of the surfaces. The dielectric between the electrodes may be an insulating material deployed as a molding or underfill compound, an adhesive film, or other spacer material. In some embodiments, a multi-layer capacitor is formed on the substrate or an IC die, e.g., a MIM capacitor. In some such embodiments, the dielectric (e.g., an oxide) is deposited over a metal layer on a surface and a metal layer is placed or deposited over the dielectric.

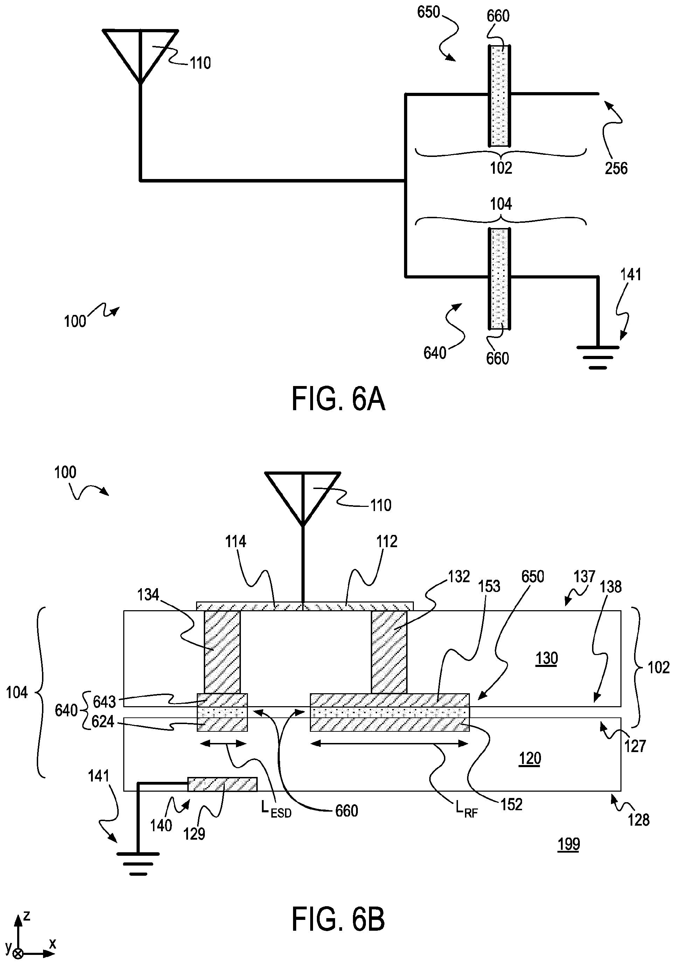

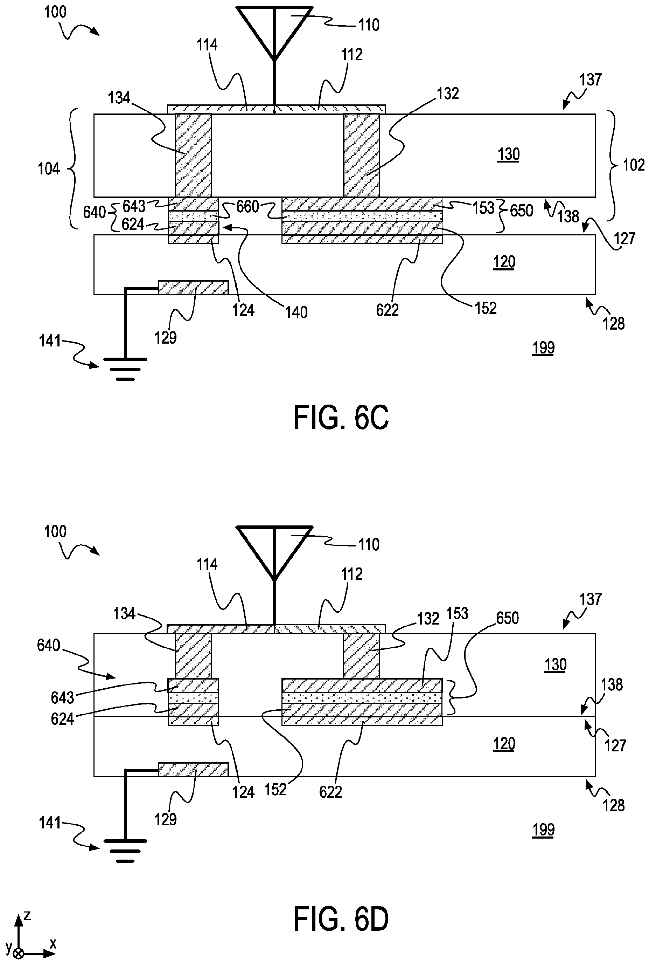

FIGS. 6A, 6B, and 6C illustrate schematic and cross-sectional profile views of antenna device 100, including antenna 110 and PNC devices 640, 650, in accordance with some embodiments. FIG. 6A shows a schematic representation of 100, including PNC devices 640, 650 between antenna 110 on one end and branches to electrical ground 141 and signal terminal 256 on the other. Antenna 110 and devices 640, 650 may be on a surface of a substrate or otherwise situated. ESD device 640 is in ESD path 104 between antenna 110 and electrical ground 141. ESD device 640 may be configured to convey an ESD pulse from antenna 110 to ground terminal 140. Signal device 650 is in signal path 102 between antenna 110 and signal terminal 256. Signal device 650 may be configured to convey a signal to or from antenna 110.

PNC devices 640, 650 are schematically represented similarly to capacitors, but with PNC 660 between parallel plates. PNC 660 includes nanoparticles or nanofillers dispersed in a polymer (or copolymer) matrix. The polymer of PNC 660 may be a dielectric material, e.g., with a high permittivity (dielectric constant). The nanoparticles may be, e.g., spheroids or other shapes with at least one dimension in the range of 1-100 nm. The nanoparticles (and the polymer between the nanoparticles) in PNC 660 (e.g., in PNCD 640, 650) may collectively model as a large network of nanodevices with very many connections (both serial and parallel) of the nanodevices between the electrodes of PNCD 640, 650. Though represented similarly schematically, PNC devices 640, 650 may be configured to behave differently by using different structures, materials, concentrations, etc. PNC devices 640, 650 may share a common PNC 660 or have different PNC 660 (for example, with different polymers and/or with different nanoparticle sizes, materials, or concentrations).

In some embodiments, the nanoparticles are metallic. PNC 660 having metallic nanoparticles may advantageously enable ESD PNC device 640 to be configured to convey an ESD pulse to and from one electrode and the other. ESD PNC device 640 may provide ESD protection for antenna 110 by conveying an ESD pulse from antenna 110 to ground terminal 140. For example, with metallic nanoparticles, the nanodevices in PNC 660 of ESD device 640 may act as spark gaps which are triggered by an ESD pulse with a sufficiently high electric field strength (e.g., corresponding to a percolation threshold of the nanodevice network). Following a triggering event (e.g., an ESD voltage pulse), ESD device 640 may provide a low ohmic conductive path through PNC 660 and allow the ESD pulse to be dissipated to electrical ground 141 through ESD path 104 (which includes ESD device 640). The electric field intensity may be increased (for example, concentrated, focused, or intensified) for a given voltage (e.g., to allow for a lower trigger voltage) by an enhanced geometry of ESD device 640. Geometry enhancements may be of the electrodes (sandwiching or bookending PNC 660) of ESD device 640. Enhanced ESD device 640 may include narrower electrodes (e.g., electrodes with smaller parallel lengths along PNC 660 and across from each other), electrodes with sharper or finer features (e.g., electrodes having features at PNC 660 with smaller radii), or electrodes closer together (e.g., across a narrower thickness of PNC 660). Geometry enhancements are described below.

Signal PNC device 650 may be configured to convey a signal, e.g., as a coupling capacitor, to and from one electrode and the other. PNC 660 having metallic nanoparticles may advantageously enable signal PNC device 650 to convey a signal, e.g., an RF signal. For example, with metallic nanoparticles, the nanodevices in PNC 660 of signal device 650 may be a network of nanocapacitors (where each nanoparticle may be a common plate shared by two connected capacitors). For a given mass of the metallic nanoparticles, the concentration or count of nanoparticles (e.g., electrodes of the nanodevices) may be increased to raise the capacitance of signal device 650 (e.g., by increasing the plate area of the nano-electrodes). In this way, a sufficient coupling capacitance may be provided by a smaller signal device 650. PNC device 650 may also act as a conventional capacitor, e.g., with an electric field through a dielectric (e.g., the polymer) and between the electrodes of device 650. In some embodiments, the polymer of PNC 660 advantageously has a high permittivity. Nanoparticles of other (e.g., ferroelectric) materials may also increase a permittivity of PNC 660 in signal device 650.

Antenna device 100 may include a low-pass filter or other structure between antenna 110 and electrical ground 141, for example, an inductor or inductive (e.g., strategically dimensioned) line, to provide a high-impedance ESD path 104 for a signal, but a low impedance ESD path 104 (e.g., a DC short) for an ESD pulse.

FIG. 6B shows a cross-sectional profile view of antenna device 100, including antenna 110 on upper surface 137 of substrate 130 and IC die 120 coupled to lower surface 138 and substrate 130 by PNC devices 640, 650 on lower surface 138. Antenna device 100 includes IC die 120 with substrate 130 between antenna 110 and IC die 120. IC die 120 is coupled to antenna 110 by substrate 130 (including vias 132, 134 of and through substrate 130) and devices 640, 650. A rigid (e.g., glass or crystalline) substrate 130 may support antenna 110 and the placement of PNC 660 and devices 640, 650 at discrete and optimal locations, for example, for minimizing interference and maximizing signal integrity and ESD suppression, e.g., away from or opposite antenna 110, in some embodiments. Substrate 130 includes electrodes 153, 643, which are metallization structures on surface 138. Electrodes 153, 643 are substantially coplanar. IC die 120 includes electrodes 152, 624, which may have a structure similar to an interconnect interface (e.g., a bond pad). Electrodes 152, 624 are substantially coplanar. PNC 660 is between IC die 120 and electrodes 153, 643 of substrate 130.

Signal device 650 is configured to convey a signal to or from antenna 110. Device 650 includes electrodes 152, 153 and PNC 660 between electrodes 152, 153. Device 650 is on and coupled to substrate 130 by electrode 153, and antenna 110 is coupled to PNC 660 by electrode 153. Device 650 and electrode 153 are coupled to antenna 110 by line 112 and via 132. Antenna 110 is coupled to IC die 120 by signal path 102, which includes line 112, via 132, and signal device 650 and is configured to convey a signal to or from antenna 110.

ESD device 640 is configured to convey an ESD pulse from antenna 110 to ground terminal 140. Device 640 includes electrodes 624, 643 and PNC 660 between electrodes 624, 643. Device 640 is on and coupled to substrate 130 by electrode 643, and antenna 110 is coupled to PNC 660 by electrode 643. Device 640 and electrode 643 are coupled to antenna 110 by line 114 and via 134. Antenna 110 is coupled to ground terminal 140 (and electrical ground 141) by ESD path 104, which includes line 114, via 134, ESD device 640, and IC die 120, including electrode 624, interconnect interface 129, and other (not shown) metallization structures and is configured to convey an ESD pulse. Signal device 650 length L_{RF} (e.g., of electrodes 153, 152) is greater than ESD device 640 length L_{ESD} (e.g., of electrodes 624, 643). ESD path 104 may include a low-pass filter, e.g., that blocks RF or other signal frequencies. The low-pass filter may be implemented with ESD line 114 and/or ESD via 134, which may be inductive (at least to the signal and at the signal frequency, e.g., due to dimensioning).

Substrate 130 and IC die 120 may be coupled by any suitable means. In some embodiments, substrate 130 and IC die 120 are soldered together, e.g., at interconnect interfaces (not shown) on surfaces 138, 127. In some embodiments, substrate 130 and IC die 120 are direct bonded, e.g., at interconnect interfaces (not shown) on surfaces 138, 127. In some such embodiments, substrate 130 and IC die 120 are hybrid bonded, including by dielectric bonds (not shown) on surfaces 138, 127. In some embodiments, interconnect interfaces (not shown) on surfaces 138, 127 are located away from PNC devices 640, 650. In some embodiments, substrate 130 and IC die 120 are bonded by an adhesive or bonding compound. In some such embodiments, the adhesive or bonding compound includes one or more components of PNC 660, such as the polymer. In some embodiments, substrate 130 and IC die 120 are bonded by PNC 660. In some embodiments, PNC 660 acts as a thermal interface material (TIM). In some such embodiments, PNC 660 assists in thermal management, for example, of IC die 120 by conducting heat away from IC die 120, e.g., upward to vias 132, 134, etc.

FIG. 6C shows a cross-sectional profile view of antenna device 100, including antenna 110 on upper surface 137 of substrate 130 and PNC devices 640, 650 on lower surface 138. Antenna device 100 is coupled to (but does not include) IC die 120. Antenna device 100 has ground and signal terminals 140, 256 at lower electrodes 624, 152 of devices 640, 650, respectively. Ground terminal 140 of antenna device 100 is coupled (by lower electrode 624) to IC die 120 (by interconnect interface 124) and to electrical ground 141 through IC die 120 and host component 199. IC die 120 includes interconnect interfaces 124, 622, which are coupled to PNC devices 640, 650 at electrodes 152, 624.

FIG. 6D illustrates a cross-sectional profile view of antenna device 100, including PNC devices 640, 650 recessed into substrate 130. Antenna device 100 may include IC die 120. Antenna 110 is coupled to IC die 120. IC die 120 includes interconnect interfaces 124, 622, which are coupled to PNC devices 640, 650 at electrodes 152, 624. Electrodes 153, 643 of devices 640, 650 are in a recess in lower surface 138 and substrate 130, and electrodes 152, 624 are on or flush with surface 138.

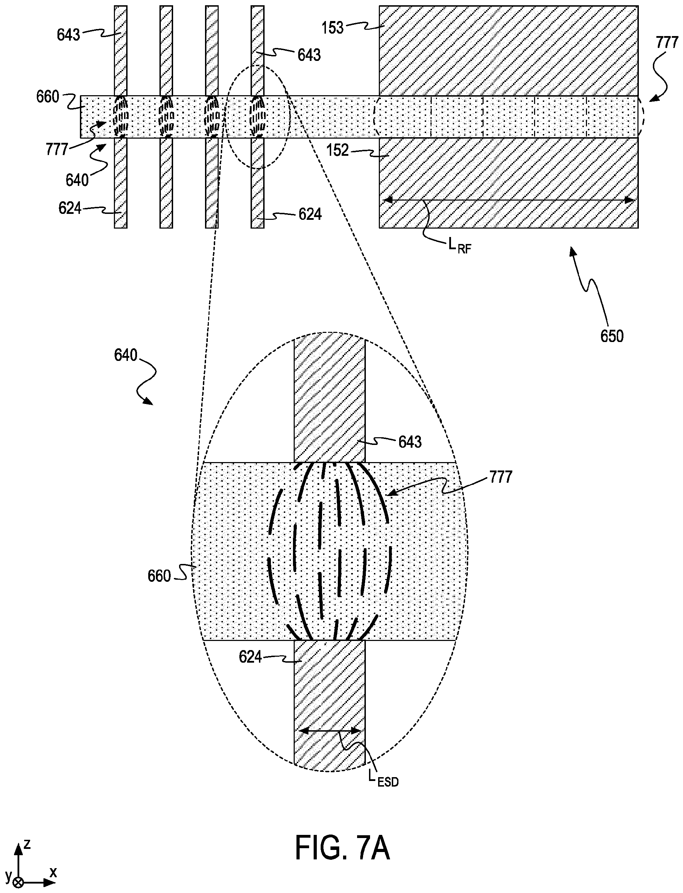

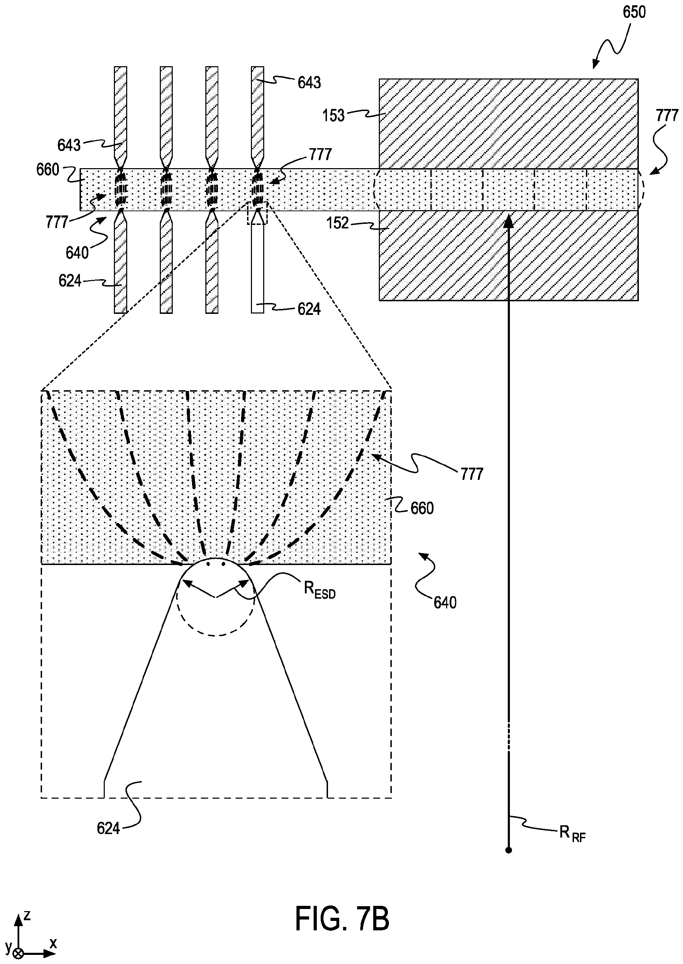

FIGS. 7A and 7B illustrate cross-sectional profile views of ESD and signal PNC devices 640, 650, including concentrated electric field lines 777 showing increased electric field intensities in ESD devices 640 with enhanced electrode geometries, in accordance with some embodiments. FIG. 7A shows devices 640 having a greater electric field intensity than device 650 (as represented by a higher density of electric field lines 777). ESD device 640 (e.g., in magnified view) has a plate length L_{ESD} of electrodes 624, 643 along PNC 660, and signal device 650 has a plate length L_{RF} of electrodes 152, 153 along PNC 660. Signal device 650 length L_{RF} is greater than ESD device 640 length L_{ESD}, and ESD device 640 has a correspondingly greater electric field intensity signal than device 650.

ESD device 640 may have an enhanced geometry, for example, to increase a local electric field strength (at PNC 660 in device 640) and trigger at a lower voltage, which may provide protection for, e.g., a signal path and/or IC die. As described in FIG. 7A, enhanced ESD device 640 may include narrower electrodes 624, 643 (e.g., electrodes 624, 643 with smaller parallel lengths along PNC 660 and across from each other), which may concentrate the electric field intensity (e.g., have a higher electric field intensity near the narrower electrodes 624, 643). Narrower electrodes 624, 643 have a shorter length of adjoining PNC 660. A concentrated electric field in PNC 660 may promote earlier triggering (e.g., by an ESD voltage pulse with a same magnitude), which may provide a low ohmic conductive path and improved ESD protection.

Multiple devices 640 (or a single device 640 with multiple upper electrodes 643 and multiple lower electrodes 624) may allow for narrow electrode geometries and correspondingly concentrated electric fields while providing multiple parallel ESD dissipation paths to ground. Multiple lower electrodes 624 or upper electrodes 643 may be separated from other electrodes 624, 643 on a same side of PNC 660 by a spacer material, e.g., an oxide.

FIG. 7B shows device 640 having a greater electric field intensity than device 650 (as represented by a higher density of electric field lines 777). Enhanced ESD device 640 (e.g., in magnified view) has electrodes 624, 643 with sharper or finer features (e.g., electrodes 624, 643 have features at PNC 660 with smaller radii R_{ESD}), which may concentrate the electric field intensity as previously described and with similar benefits. ESD device 640 has plate feature radius R_{ESD} at PNC 660, and signal device 650 has plate feature radius R_{RF} at PNC 660. (The plates or electrodes of signal device 650 are flat, so electrode radius R_{RF} is effectively infinity.) Signal device 650 radius R_{RF} is greater than ESD device 640 radius R_{ESD}, and ESD device 640 has a greater electric field intensity signal than device 650.

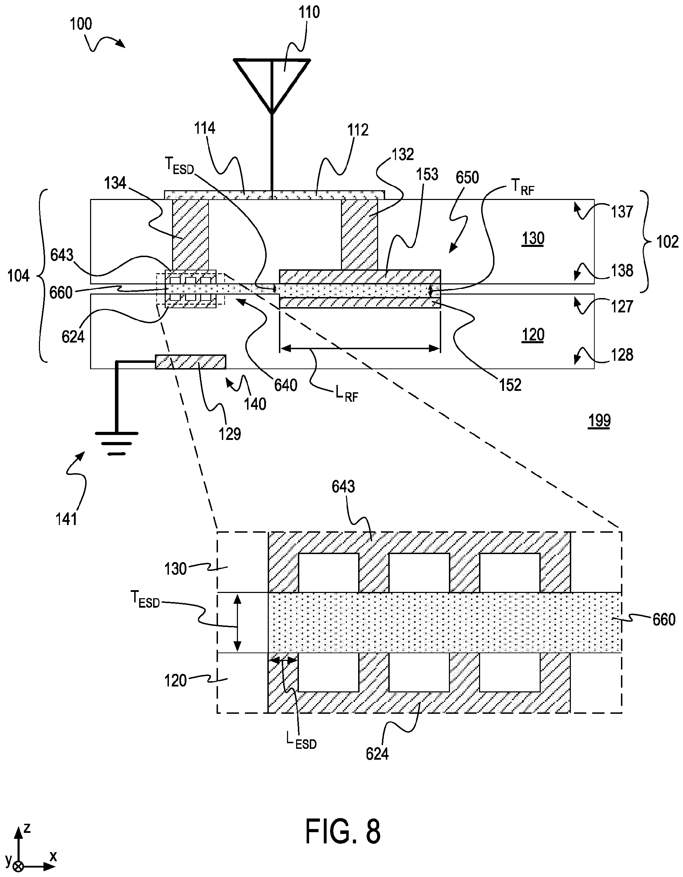

FIG. 8 illustrates a cross-sectional profile view of antenna device 100, including PNC devices 640, 650 sharing a common layer of PNC 660 between IC die 120 and substrate 130, in accordance with some embodiments. PNC 660 of device 640 and PNC 660 of device 650 are in a layer shared by PNC devices 640, 650. Electrodes 153, 643 are substantially coplanar. Electrode 152 of device 650 and IC die 120 is in a recess in upper surface 127 and IC die 120. In some embodiments, PNC 660 in signal device 650 has the same composition as PNC 660 in ESD device 640, but ESD device 640 triggers at a lower ESD voltage than signal device 650. A thickness T_{RF} of PNC 660 between electrodes 152, 153 in signal device 650 is greater than a thickness T_{ESD} of PNC 660 between electrodes 624, 643 in ESD device 640. This electrode geometry may enable a higher, concentrated electric field intensity in ESD device 640 than in signal device 650, which may advantageously allow ESD device 640 to trigger at a lower, e.g., ESD voltage than signal device 650.

A length L_{RF} of PNC 660 in signal device 650 adjoining electrodes 152, 153 in signal device 650 is greater than a length L_{ESD} of PNC 660 in ESD device 640 adjoining electrodes 624, 643. This enhanced electrode geometry of ESD device 640 may have benefits as described elsewhere herein, e.g., at least at FIG. 7A. ESD device 640 in FIG. 8 may have multiple lower electrodes 624 and upper electrodes 643. ESD device 640 in FIG. 8 may have a single lower electrode 624 and a single upper electrode 643, but each with multiple lengths L_{ESD} of PNC 660 adjoining electrodes 624, 643. This structure may have benefits as described elsewhere herein, e.g., at least that of multiple parallel ESD dissipation paths to ground as described at FIG. 7A. In some embodiments, electrodes 624, 643 of ESD device 640 have finer features (e.g., with smaller radii R_{ESD}) than electrodes 152, 153 in signal device 650.

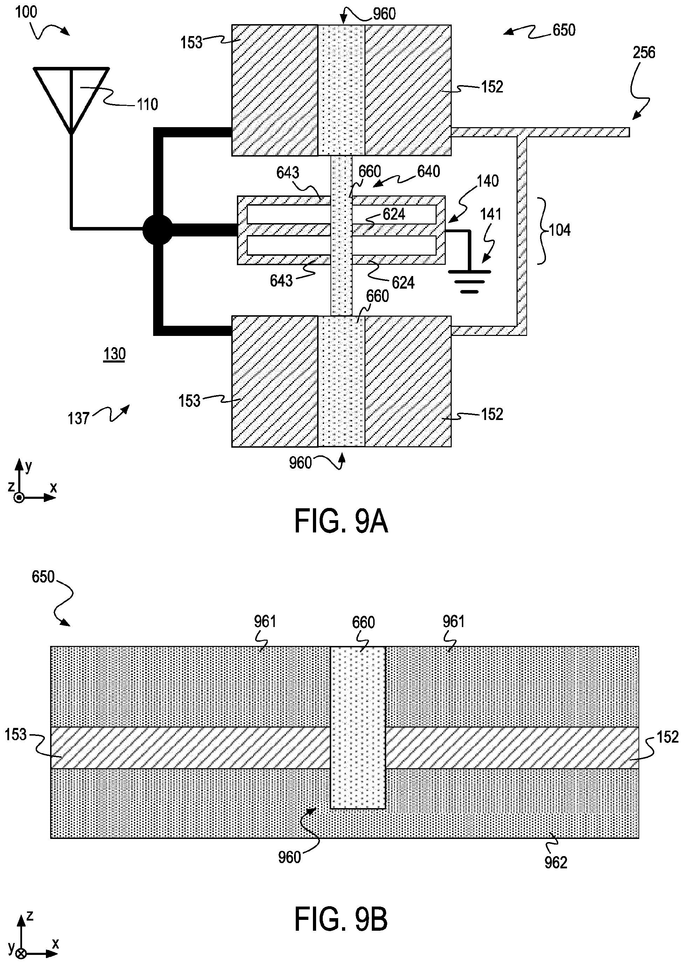

FIGS. 9A and 9B illustrate plan and cross-sectional profile views of antenna device 100, including PNC 660 deployed in a trench 960 in substantially planar ESD and signal devices 640, 650, in accordance with some embodiments. FIG. 9A shows a plan view of ESD device 640 and signal devices 650 with PNC 660 in one or more strips or trenches 960 between coplanar electrodes 624, 643 and between coplanar electrodes 152, 153 in a shared metal layer. Signal devices 650 are part of a signal path to and from antenna 110 (e.g., between antenna 110 and signal terminal 256). Signal devices 650 are configured to convey a signal to and from antenna 110. ESD device 640 is part of ESD path 104, and is configured to convey an ESD pulse, from antenna 110 to ground terminal 140 and electrical ground 141. In some embodiments, PNC 660 is in a single trench 960 shared amongst devices 640, 650. A single trench 960 for multiple devices 640, 650 may enable a more compact device layout (e.g., by saving substrate or die area). In some embodiments, each device 640, 650 has a distinct trench 960 with PNC 660. In some such embodiments, devices 640, 650 have distinct trenches 960 and PNC 660 and improved isolation (e.g., ESD or signal isolation). In some embodiments, distinct trenches 960 and PNC 660 enable layout flexibility. In some embodiments, devices 640, 650 have PNC 660 with the same composition, e.g., in a shared trench. In other embodiments, devices 640, 650 have separate, distinct trenches and PNC 660 with differing compositions. In some such embodiments, devices 640, 650 have PNC 660 with a same polymer and similar nanoparticles, but PNC 660 in ESD device 640 has a different concentration of nanoparticles. In some embodiments, PNC 660 in signal device 650 has a different polymer, e.g., with a higher permittivity.

Antenna 110 may be implemented as previously discussed. In the example of FIG. 9A, antenna 110 and devices 640, 650 are on upper surface 137 of substrate 130. In some embodiments, antenna 110 and devices 640, 650 are on opposite surfaces, for example, with antenna 110 on upper surface 137 of substrate 130 and devices 640, 650 on lower surface 138. In some embodiments, devices 640, 650 are on opposite surfaces, for example, with device 650 on upper surface 137 and device 640 on lower surface 138.

ESD device 640 has a shorter plate length of electrodes 624, 643 along PNC 660 than signal device 650 and electrodes 152, 153. ESD device 640 has a thinner strip of PNC 660 between electrodes 624, 643 in trench 960 than signal device 650 between electrodes 152, 153. In some embodiments, ESD device 640 has electrodes 624, 643 with sharper or finer features (e.g., features at PNC 660 with smaller radii) than signal device 650 and electrodes 152, 153. These electrode geometries may advantageously allow ESD device 640 to trigger at a lower voltage than signal device 650.

FIG. 9B illustrates PNC device 650 (or PNC device 640) with PNC 660 in strip or trench 960 between coplanar electrodes 152, 153 (or electrodes 624, 643) in a single metal layer. Trench 960 and PNC 660 are between electrodes 152, 153. Trench 960 is in an upper insulator 961 over the metal layer that includes coplanar electrodes 152, 153. Trench 960 is in a lower insulator 962 under the metal layer that includes coplanar electrodes 152, 153.

Lower insulator 962 may be an upper layer of a structure below, for example, surface 137 of substrate 130. In some embodiments, lower insulator 962 and PNC device 640 and/or 650 are on lower surface 138. In some embodiments, lower insulator 962 and PNC device 640 and/or 650 are over an IC die. In some embodiments, lower insulator 962 is glass or silicon. In some embodiments, lower insulator 962 is a layer over an upper layer of a structure below, for example, an oxide film on a glass or silicon substrate or IC die.

Upper insulator 961 may be in a layer over coplanar electrodes 152, 153 and may also be a layer over a structure below, for example, an oxide film on a glass or silicon substrate or IC die. In some embodiments, upper insulator 961 is in a layer over lower insulator 962 beyond the edges of PNC devices 640, 650. In some embodiments, upper insulator 961 is in a layer confined to PNC devices 640, 650.

In some embodiments, PNC device 640 is implemented with PNC 660 in trench 960 between coplanar electrodes 624, 643 in a single metal layer. PNC device 640 may have a narrower trench 960 and thinner strip of PNC 660 between electrodes 624, 643 than PNC device 650 between electrodes 152, 153. PNC device 640 may have a shorter trench 960 and strip of PNC 660 along (e.g., in the y direction, into the viewing plane) and between electrodes 624, 643 than PNC device 650 along and between electrodes 152, 153. PNC device 640 may have electrodes 624, 643 with finer features (e.g., smaller feature radii) than PNC device 650 and electrodes 152, 153.

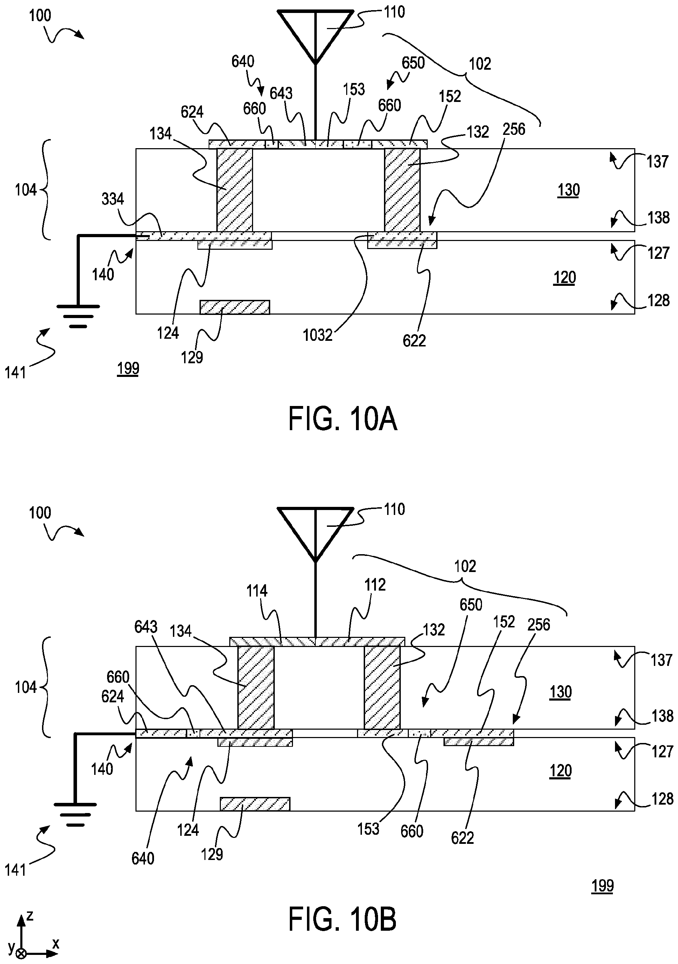

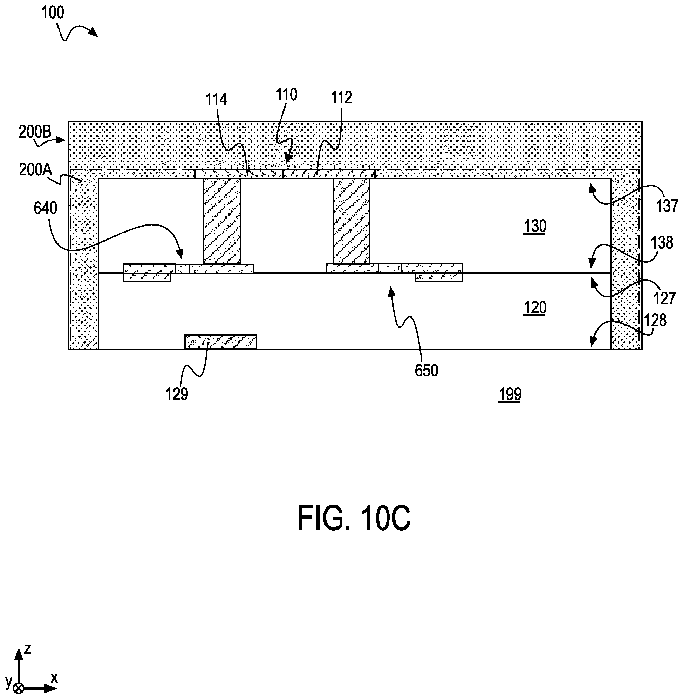

FIGS. 10A, 10B, and 10C illustrate cross-sectional profile views of antenna device 100, including PNC devices 640, 650 on upper and lower surfaces 137, 138 of substrate 130, in accordance with some embodiments. FIG. 10A shows antenna device 100 with PNC devices 640, 650 on upper surface 137 of substrate 130. IC die 120 is coupled to antenna device 100. IC die 120 includes interconnect interfaces 124, 622 on upper surface 127. Antenna device 100 includes ground terminal 140 (at ESD line 334) and signal terminal 256 (at interconnect interface 1032) on lower surface 138. Interconnect interfaces 124, 622 are coupled to ESD line 334 and interconnect interface 1032. ESD line 334 (and antenna device 100) may be coupled to electrical ground 141 by IC die 120 or another structure coupled to substrate 130, e.g., directly to host component 199 or another connection to electrical ground 141.

Signal path 102 includes signal device 650, which is configured to convey a signal to or from antenna 110, e.g., to or from signal terminal 256 and IC die 120. Signal device 650 includes coplanar electrodes 152, 153 and PNC 660 between electrodes 152, 153, e.g., in a trench as described at least in FIGS. 9A and 9B. Electrode 153 is coupled to antenna 110. Electrode 152 is coupled to signal terminal 256 and IC die 120. Antenna 110 is coupled to PNC 660 by electrode 153.

ESD path 104 includes ESD device 640, which is configured to convey an ESD pulse to ground terminal 140 and electrical ground 141. ESD device 640 includes coplanar electrodes 624, 643 and PNC 660 between electrodes 624, 643, e.g., in a trench. PNC 660 in signal device 650 has a greater thickness than PNC 660 in ESD device 640. ESD device 640 may have one or more other beneficial geometries, such as short or narrow electrodes 624, 643. Electrode 643 is coupled to antenna 110. Electrode 624 is coupled to ground terminal 140 and electrical ground 141. Antenna 110 is coupled to PNC 660 by electrode 643.

FIG. 10B illustrates antenna device 100 with PNC devices 640, 650 on lower surface 138 of substrate 130. IC die 120 is coupled to antenna device 100. IC die 120 includes interconnect interfaces 124, 622 on upper surface 127. Antenna device 100 includes ground terminal 140 (at electrode 624) and signal terminal 256 (at electrode 152) on lower surface 138. Interconnect interfaces 124, 622 are coupled to electrodes 643, 152. Electrode 624 (and antenna device 100) may be coupled to electrical ground 141 by IC die 120 or another structure coupled to substrate 130, e.g., directly to host component 199 or another connection to electrical ground 141.

Signal path 102 includes signal device 650, which is configured to convey a signal to or from antenna 110, e.g., to or from signal terminal 256 and IC die 120. Signal device 650 includes coplanar electrodes 152, 153 and PNC 660 between electrodes 152, 153, e.g., in a trench. Electrode 153 is coupled to antenna 110. Electrode 152 and signal terminal 256 are coupled to IC die 120. Antenna 110 is coupled to PNC 660 by electrode 153.

ESD path 104 includes ESD device 640, which is configured to convey an ESD pulse to ground terminal 140 and electrical ground 141. ESD device 640 includes coplanar electrodes 624, 643 and PNC 660 between electrodes 624, 643, e.g., in a trench. PNC 660 in signal device 650 has a greater thickness than PNC 660 in ESD device 640. ESD device 640 may have other beneficial geometries, such as finer (e.g., sharp) features on electrodes 624, 643, e.g., with very small feature radii. Electrode 643 is coupled to antenna 110. Electrode 624 and ground terminal 140 are coupled to electrical ground 141. Antenna 110 is coupled to PNC 660 by electrode 643.

FIG. 10C illustrates antenna device 100, including IC die 120 coupled to substrate 130, encapsulated in a package dielectric 200B. Package dielectric 200A, 200B may be any suitable material. In some embodiments, package dielectric 200A, 200B includes an organic material, such as a mold compound or other polymer. In some embodiments, package dielectric 200A, 200B includes an inorganic material, such as an oxide (e.g., silicon dioxide) or other ceramic material. Antenna device 100 is coupled to a power supply (not shown) through host component 199 by an interconnect interface (not shown). Antenna device 100 is coupled to a system electrical ground through host component 199 by interconnect interface 129. Package dielectric 200B is over upper surface 137 of substrate 130 (including lines 112, 114, and planar antenna 110), over host component 199, and around substrate 130 and IC die 120 on all sides. In some embodiments, antenna device 100 is encapsulated in a package dielectric 200A, which is over host component 199 and around substrate 130 and IC die 120, but is flush with antenna 110 and lines 112, 114 over substrate 130.

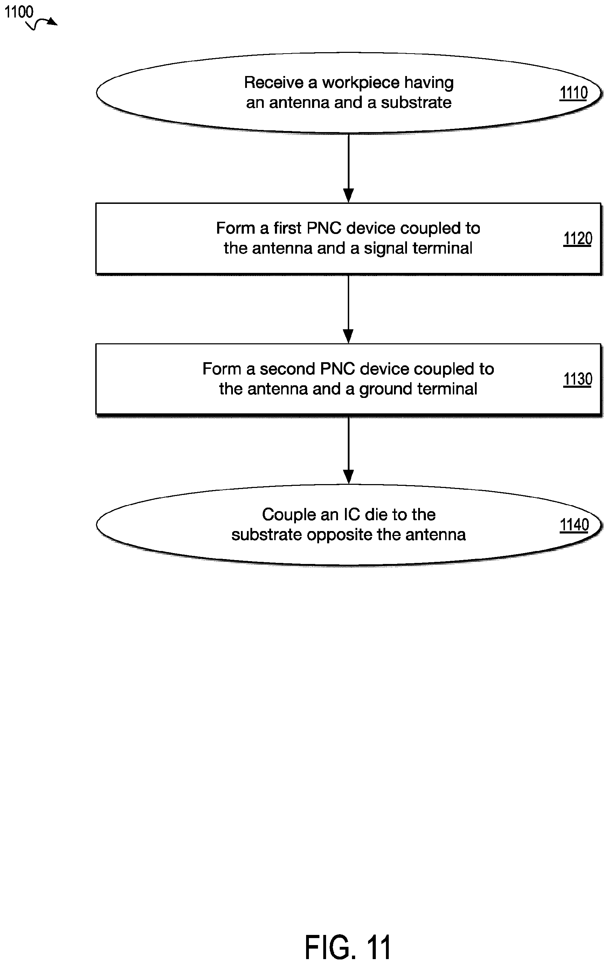

FIG. 11 is a flow chart of methods 1100 for forming an antenna device, including forming PNC devices coupled to an antenna, in accordance with some embodiments. Methods 1100 include operations 1110-1140. Some operations shown in FIG. 11 are optional. Additional operations may be included. FIG. 11 shows an example sequence, but the operations can be done in other orders as well, and some operations may be omitted. Some operations can also be performed multiple times before other operations are performed. For example, multiple PNC devices may be formed and coupled to the antenna and various terminals. Some operations may be included within other operations so that the number of operations illustrated FIG. 11 is not a limitation of the methods 1100.

Methods 1100 begin at operation 1110, where a workpiece, including a substrate and an antenna, is received. In some embodiments, an IC die is also received. In some embodiments, parts or materials for the received structures and the structures may be formed from the parts or materials. For example, metal may be received for forming an antenna.

The substrate may be substantially as previously described, for example, at FIGS. 1 or 5, or in some state of partial manufacture, e.g., not yet with all of the eventual metallization structures. For example, the substrate may be a planar platform including an insulator or semiconductor material, such as a plastic, silicon, glass, or other insulator or semiconductor material. In some embodiments, the substrate is an IC die. In some embodiments, the substrate includes a monolithic core between layers, e.g., of organic material(s). The received substrate may include electrical lines on one or more surfaces and/or electrical lines through the substrate, e.g., through vias and/or electrical lines parallel to a surface.

The antenna may be any suitable structure. The antenna may be on the substrate as received. In some embodiments, the antenna is a planar antenna on a surface of the substrate, e.g., a microstrip antenna. In some embodiments, the antenna is one of multiple antennas, for example, in one or multiple layers on the substrate. In some embodiments, the antenna is nonplanar, e.g., in multiple layers, extending from a layer, etc. The antenna may be formed, e.g., on the received substrate, with received materials, such as one or more metals. The antenna may be formed in a manner described at operation 520 of methods 500.

At operation 1120, a PNC device may be formed. The PNC device may be a signal device, e.g., configured to convey a signal between electrodes. For example, the PNC device may be a capacitor or have a similar structure as a capacitor. The PNC device may be formed with certain dimensions, such as electrode area and spacing, to optimize signal transmission between electrodes. These dimensions may be adapted to a desired signal characteristic, for example, frequency or wavelength. The PNC device may include two electrodes (e.g., metallization or other electrically conductive structures, such as plates) and PNC material between the electrodes. The PNC device may be formed by assembling these parts. In some embodiments, the electrodes are brought together with the PNC material between them. In some embodiments, the PNC material is applied or dispensed between the electrodes.

The electrodes may be formed of any suitable material(s) and by any suitable means. For example, one or both of the electrodes may be on a surface of the substrate, and the electrode(s) may be formed with conventional means for forming metallization structures on a substrate. In some embodiments, one or both electrodes are formed concurrently with the antenna. In some embodiments, metal is deposited on and/or removed (e.g., etched) from a surface, for example, with conventional patterning and/or lithography techniques.

The PNC material may be as previously described, for example, at FIG. 6A. The PNC material may include nanoparticles within a polymer. The PNC material may include one or more high-permittivity materials, e.g., the polymer. The nanoparticles may be of or include a conductive material. The PNC material may be formed, e.g., dispensed, as a viscous fluid, for example, above a glass-transition temperature of the polymer. In some embodiments, a thin layer of the PNC material is applied or formed, e.g., over an electrode. In some such embodiments, the polymer is viscoelastic (e.g., an elastomer) and is placed, for example, in a layer over an electrode or in a strip between electrodes.

The PNC material may be received, for example, at operation 1110, or may be formed separately. Separate formation may allow for adapting of the PNC material, e.g., for altering characteristics of the polymer (e.g., a viscosity of permittivity) or of the nanoparticles (e.g., a concentration). In some embodiments, the polymer is similar to one commonly used in semiconductor packaging, for example, in an adhesive or bonding compound or a TIM. In some embodiments, the nanoparticles are mixed into a resin before polymerization. In some embodiments, the nanoparticles are mixed into the polymer above the glass-transition temperature. In some embodiments, the nanoparticles are mixed in a solution before mixing with the polymer (or resin, etc., before polymerization).

The PNC device may be formed by forming (e.g., applying) the PNC material in a strip or trench between the electrodes. The trench may be formed by patterning metal in the layer, for example, with metal electrodes on both sides of a gap between the electrodes. In some embodiments, the trench is a void in multiple layers, including an insulator layer (e.g., an oxide) over and/or under the layer of the electrode. Forming one or more insulator layers above and/or below an electrode layer may allow for more repeatability in the manufacturing of PNC devices, for example, in the forming of PNC material between the electrodes and of the structure (such as a trench) for containing the PNC material.

The PNC device may be formed by forming the PNC material in a layer between the electrodes. In some embodiments, the PNC material is formed in a layer over an electrode and a second electrode is aligned and placed over the first electrode with the PNC material between the two electrodes. In some embodiments, the PNC device is on a surface of the substrate with one electrode over the PNC material and the substrate surface. In some embodiments, the PNC device is on a surface of the substrate with one electrode at (e.g., flush with) the substrate surface and over the PNC material and the other electrode.

The PNC device may be coupled to the antenna and a signal terminal, e.g., as part of a signal path to or from the antenna. For example, one electrode may be coupled to the antenna (e.g., on an upper surface of the substrate) and the other electrode to the signal terminal (e.g., on a lower surface of the substrate). In some embodiments, the PNC device is coupled to the signal terminal by one of the electrodes being (or including) the signal terminal. In some such embodiments, the signal terminal is formed by forming the signal PNC device. In some embodiments, the antenna and both electrodes are on a same surface of the substrate. The electrodes may be substantially coplanar in a single metal layer on the substrate. In some embodiments, a metallization structure on a substrate surface includes an electrode portion of a PNC device and an antenna portion. In some embodiments, the PNC device is coupled to the antenna and signal terminal upon formation. For example, the electrodes and metallization coupling the electrodes to the antenna and signal terminal may be formed on the substrate as received or after receipt, and the PNC material may be formed between the electrodes to complete the signal path. In some embodiments, the PNC device is coupled to the antenna and signal terminal after formation.

A second PNC device may be formed at operation 1130. The second PNC device may be an ESD device, e.g., configured to convey an ESD pulse between electrodes, through a PNC material. The second PNC device may be formed in a similar manner and with a structure similar to the first PNC device, but the second PNC device may be formed to trigger at a lower voltage. Triggering may happen at a critical electric field during the ESD event where the device breaks down and forms a low ohmic conduction path between electrodes, through the polymer and between nanoparticles. For example, to increase the electric field for a given voltage, an ESD PNC device may be formed with a shorter length of PNC material between and abutting the electrodes than in a signal PNC device. The PNC material may continue along and beyond multiple electrodes but with a shorter length along any single electrode because of thinner electrodes, e.g., between insulating spacers, for example, of an oxide. In some embodiments, the second PNC device is formed with a narrower thickness of PNC material between and abutting the electrodes. In some embodiments, the second PNC device is formed with finer electrode features (e.g., with smaller feature radii at the PNC material). A signal PNC device may benefit from a higher concentration of nanoparticles in the PNC material (e.g., from the elevated capacitance of the added surface area of, and reduced distance between, nanoparticles) relative to an ESD PNC device. In some embodiments, the second PNC device is formed with a lower concentration of nanoparticles in the PNC material.

This second PNC device may be coupled to the antenna and a ground terminal, e.g., as part of a ground path from the antenna. The second PNC device may be situated similarly to the first PNC device. One or both electrodes (and the PNC material between) may be on a surface of the substrate. As with the first PNC device, one or both electrodes of the second PNC device may be over or under the substrate. In some embodiments, one electrode is coupled to the antenna (e.g., on an upper surface of the substrate) and the other electrode to the ground terminal (e.g., on a lower surface of the substrate). The ground terminal may be a conductor, such as an interconnect interface, and may be configured to couple to an electrical ground connection, for example, of another substrate, including an IC die or other host component. In some embodiments, the PNC device is coupled to the ground terminal by one of the electrodes being (or including) the ground terminal. In some such embodiments, the ground terminal is formed by forming the ESD PNC device.

At operation 1140, an IC die may optionally be received and coupled to the substrate opposite the antenna. The IC die may be received with the substrate and antenna or separately (for example, before or after the substrate and antenna). The IC die may be as previously described, e.g., an RF IC having transmitter and/or receiver circuitry. The IC die may include one or more interconnect interfaces, such as bond pads, for coupling to the substrate. One or more such interconnect interfaces may couple to the ground terminal or the signal terminal. For example, a signal path to or from the antenna may include a signal PNC device between the antenna and the signal terminal for coupling the signal between the antenna and the IC die. An I/O port of the IC die may connect to the signal terminal to couple the antenna to the IC die. A ground path from the antenna may include an ESD PNC device between the antenna and the ground terminal for coupling an ESD pulse between the antenna and electrical ground. A ground pad of the IC die may connect to the ground terminal to couple the antenna to electrical ground through the IC die.

Coupling the IC die to the substrate may be performed concurrently with other operations. For example, forming one or both of the first and second PNC devices may include coupling the IC die to the substrate. In some embodiments, upper electrodes of both a signal PNC device and an ESD PNC device are interconnect interfaces on a lower surface of the substrate, and lower electrodes of both the signal and ESD PNC devices are interconnect interfaces on an upper surface of the IC die. Both PNC devices may be formed by coupling the IC die to the substrate, including by aligning and bringing the interconnect interfaces (e.g., upper and lower electrodes) together with PNC material between the electrodes. In at least some such embodiments, coupling the IC die includes forming PNC material on the IC die or the substrate. For example, PNC material may be formed on interconnect interfaces of one or both the IC die or the substrate, e.g., before the interconnect interfaces are aligned and brought together. The IC die and the substrate may be coupled by the PNC material, which may act as an adhesive between them. In some such embodiments, the IC die and the substrate may be further coupled by other means.

Coupling the IC die to the substrate may be performed by any suitable means. In some embodiments, the PNC material is applied between the IC die and the substrate, and the PNC material adheres to both the IC die and the substrate. As described at least at operation 530 of methods 500, the IC die may be soldered or direct bonded to the substrate. In some embodiments, the IC die may be direct bonded, including hybrid bonded. Direct bonding may allow for coupling the substrate and die at lower temperatures (e.g., than soldering). For example, thermo-compression bonding may be at low temperatures. Direct bonding at room temperature (e.g., with compression only) is possible, particularly if pre-processing is employed, for example, to activate one or more surfaces for bonding. Selective heating may be employed to form or strengthen a bond and may employ a laser or other means to localize heating to a specific region or structure (e.g. interconnect interfaces).

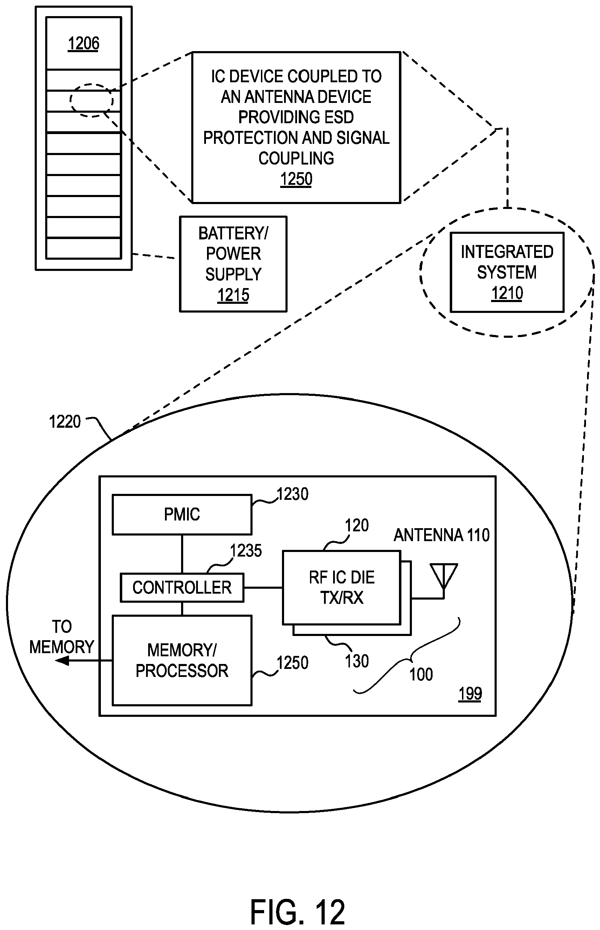

FIG. 12 illustrates a diagram of an example data server machine 1206 employing antenna device 100 providing ESD protection and signal coupling, in accordance with some embodiments. Server machine 1206 may be any commercial server, for example, including any number of high-performance computing platforms disposed within a rack and networked together for electronic data processing, which in the exemplary embodiment includes one or more devices 1250 in a system 1210 having antenna device 100 providing ESD protection and signal coupling.

Also as shown, server machine 1206 includes a battery and/or power supply 1215 to provide power to devices 1250, and to provide, in some embodiments, power delivery functions such as power regulation. Devices 1250 may be deployed as part of a package-level integrated system 1210. Integrated system 1210 is further illustrated in the expanded view 1220. In the exemplary embodiment, devices 1250 (labeled "Memory/Processor") include at least one memory chip (e.g., random-access memory (RAM)), and/or at least one processor chip (e.g., a microprocessor, a multi-core microprocessor, or graphics processor, or the like). In an embodiment, device 1250 is a microprocessor including a static RAM (SRAM) cache memory. As shown, device 1250 may be part of system 1210 including antenna device 100 providing ESD protection and signal coupling, as discussed herein. Device 1250 may be further coupled to (e.g., communicatively coupled to) a board, an interposer, or a host component 199 along with, one or more of a power management IC (PMIC) 1230, RF (wireless) IC (RFIC) die 120 including a wideband RF (wireless) transmitter and/or receiver (TX/RX) (e.g., including a digital baseband and an analog front end module further includes a power amplifier on a transmit path and a low noise amplifier on a receive path), and a controller 1235 thereof. RF IC die 120 is coupled to antenna 110 through substrate 130 in antenna device 100 providing ESD protection and signal coupling.

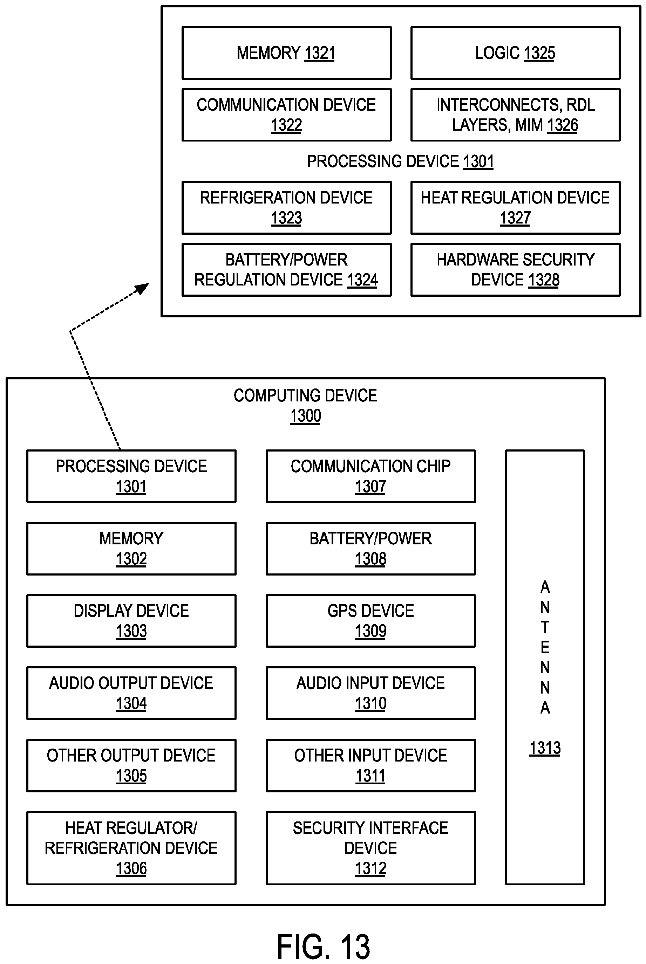

FIG. 13 is a block diagram of an example computing device 1300, in accordance with some embodiments. For example, one or more components of computing device 1300 may include any of the devices or structures discussed herein. A number of components are illustrated in FIG. 13 as being included in computing device 1300, but any one or more of these components may be omitted or duplicated, as suitable for the application. In some embodiments, some or all of the components included in computing device 1300 may be attached to one or more printed circuit boards (e.g., a motherboard). In some embodiments, various ones of these components may be fabricated onto a single system-on-a-chip (SoC) die. Additionally, in various embodiments, computing device 1300 may not include one or more of the components illustrated in FIG. 13, but computing device 1300 may include interface circuitry for coupling to the one or more components. For example, computing device 1300 may not include a display device 1303, but may include display device interface circuitry (e.g., a connector and driver circuitry) to which display device 1303 may be coupled. In another set of examples, computing device 1300 may not include an audio output device 1304, other output device 1305, global positioning system (GPS) device 1309, audio input device 1310, or other input device 1311, but may include audio output device interface circuitry, other output device interface circuitry, GPS device interface circuitry, audio input device interface circuitry, audio input device interface circuitry, to which audio output device 1304, other output device 1305, GPS device 1309, audio input device 1310, or other input device 1311 may be coupled.

Computing device 1300 may include a processing device 1301 (e.g., one or more processing devices). As used herein, the term "processing device" or "processor" indicates a device that processes electronic data from registers and/or memory to transform that electronic data into other electronic data that may be stored in registers and/or memory. Processing device 1301 may include a memory 1321, a communication device 1322, a refrigeration device 1323, a battery/power regulation device 1324, logic 1325, interconnects 1326 (i.e., optionally including redistribution layers (RDL) or MIM devices), a heat regulation device 1327, and a hardware security device 1328.

Processing device 1301 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices.

Computing device 1300 may include a memory 1302, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 1302 includes memory that shares a die with processing device 1301. This memory may be used as cache memory and may include embedded dynamic random-access memory (eDRAM) or spin transfer torque magnetic random-access memory (STT-MRAM).

Computing device 1300 may include a heat regulation/refrigeration device 1306. Heat regulation/refrigeration device 1306 may maintain processing device 1301 (and/or other components of computing device 1300) at a predetermined low temperature during operation.

In some embodiments, computing device 1300 may include a communication chip 1307 (e.g., one or more communication chips). For example, the communication chip 1307 may be configured for managing wireless communications for the transfer of data to and from computing device 1300. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 1307 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 1307 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 1307 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 1307 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 1307 may operate in accordance with other wireless protocols in other embodiments. Computing device 1300 may include one or more antennas 1313 to facilitate wireless communications and/or to receive other wireless communications (such as AM or FM radio transmissions). In some embodiments, one antenna 1313 is an antenna 110 as described elsewhere herein (e.g., on or coupled to a substrate as part of an antenna device providing ESD protection).

In some embodiments, communication chip 1307 may manage wired communications, such as electrical, optical, or any other suitable communication protocols (e.g., the Ethernet). As noted above, communication chip 1307 may include multiple communication chips. For instance, a first communication chip 1307 may be dedicated to shorter-range wireless communications such as Wi-Fi or Bluetooth, and a second communication chip 1307 may be dedicated to longer-range wireless communications such as GPS, EDGE, GPRS, CDMA, WiMAX, LTE, EV-DO, or others. In some embodiments, a first communication chip 1307 may be dedicated to wireless communications, and a second communication chip 1307 may be dedicated to wired communications. In some embodiments, communication chip 1307 is an IC die 120 as described elsewhere herein (e.g., coupled to a substrate in an antenna device providing ESD protection).

Computing device 1300 may include battery/power circuitry 1308. Battery/power circuitry 1308 may include one or more energy storage devices (e.g., batteries or capacitors) and/or circuitry for coupling components of computing device 1300 to an energy source separate from computing device 1300 (e.g., AC line power).

Computing device 1300 may include a display device 1303 (or corresponding interface circuitry, as discussed above). Display device 1303 may include any visual indicators, such as a heads-up display, a computer monitor, a projector, a touchscreen display, a liquid crystal display (LCD), a light-emitting diode display, or a flat panel display, for example.

Computing device 1300 may include an audio output device 1304 (or corresponding interface circuitry, as discussed above). Audio output device 1304 may include any device that generates an audible indicator, such as speakers, headsets, or earbuds, for example.

Computing device 1300 may include an audio input device 1310 (or corresponding interface circuitry, as discussed above). Audio input device 1310 may include any device that generates a signal representative of a sound, such as microphones, microphone arrays, or digital instruments (e.g., instruments having a musical instrument digital interface (MIDI) output).

Computing device 1300 may include a GPS device 1309 (or corresponding interface circuitry, as discussed above). GPS device 1309 may be in communication with a satellite-based system and may receive a location of computing device 1300, as known in the art.

Computing device 1300 may include other output device 1305 (or corresponding interface circuitry, as discussed above). Examples of the other output device 1305 may include an audio codec, a video codec, a printer, a wired or wireless transmitter for providing information to other devices, or an additional storage device.

Computing device 1300 may include other input device 1311 (or corresponding interface circuitry, as discussed above). Examples of the other input device 1311 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 1300 may include a security interface device 1312. Security interface device 1312 may include any device that provides security measures for computing device 1300 such as intrusion detection, biometric validation, security encode or decode, access list management, malware detection, or spyware detection.

Computing device 1300, or a subset of its components, may have any appropriate form factor, such as a hand-held or mobile computing device (e.g., a cell phone, a smart phone, a mobile internet device, a music player, a tablet computer, a laptop computer, a netbook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

The subject matter of the present description is not necessarily limited to specific applications illustrated in FIGS. 1-13. The subject matter may be applied to other deposition applications, as well as any appropriate manufacturing application, as will be understood to those skilled in the art.

The following examples pertain to further embodiments, and specifics in the examples may be used anywhere in one or more embodiments.

In one or more first embodiments, an apparatus includes a glass substrate, including first and second vias, each spanning between first and second surfaces of the glass substrate, an antenna on the first surface, wherein the antenna is coupled to the first and second vias, and an IC die adjacent the second surface, the IC die including a first trace or pad coupled to the first via and to ground, the IC die also including a second trace or pad capacitively coupled to the antenna through the second via.

In one or more second embodiments, further to the first embodiments, a path running from the antenna through the first via and to ground includes a portion of the IC die.

In one or more third embodiments, further to the first or second embodiments, the glass substrate and the IC die are direct bonded together.

In one or more fourth embodiments, further to the first through third embodiments, the IC die is coupled to a power supply through a host component, and the IC die is between the glass substrate and the host component.

In one or more fifth embodiments, further to the first through fourth embodiments, the second trace or pad is capacitively coupled to the second via by a capacitor including first and second electrodes, the glass substrate includes the first electrode, and the IC die includes the second electrode.

In one or more sixth embodiments, further to the first through fifth embodiments, a package dielectric is around the IC die and the glass substrate.

In one or more seventh embodiments, further to the first through sixth embodiments, a path running from the antenna through the first via and to ground has a length of less than 3 mm.

In one or more eighth embodiments, further to the first through seventh embodiments, the glass substrate has a thickness of less than 500 µm.

In one or more ninth embodiments, an apparatus includes a substrate, including first and second vias, each spanning between first and second surfaces of the substrate, an antenna on the first surface, wherein the antenna is coupled to the first and second vias and to receive or transmit a signal, the signal having a wavelength, a first path from the antenna to a ground terminal, wherein the first path includes the first via and has an electrical length approximately equal to a quarter of the wavelength, and a second path to or from the antenna, wherein the second path includes the second via and at least a first electrode of a capacitor.

In one or more tenth embodiments, further to the ninth embodiments, the apparatus also includes an IC die coupled to the signal second path, and the capacitor is on the first or second surface.

In one or more eleventh embodiments, further to the ninth or tenth embodiments, the substrate includes the first electrode, and the IC die includes a second electrode of the capacitor.

In one or more twelfth embodiments, further to the ninth through eleventh embodiments, the IC die is between the ground terminal and the substrate.

In one or more thirteenth embodiments, further to the ninth through twelfth embodiments, the IC die is coupled to a power supply.

In one or more fourteenth embodiments, further to the ninth through thirteenth embodiments, the substrate includes a glass layer, and the first and second vias extend through the glass layer.

In one or more fifteenth embodiments, further to the ninth through fourteenth embodiments, the first path has an electrical length greater than 23% of the wavelength and less than 27% of the wavelength.

In one or more sixteenth embodiments, a method includes receiving a workpiece including a substrate, coupling an IC die to an antenna by coupling the IC die to a first surface of the substrate, wherein the antenna is on a second surface of the substrate, the second surface distal the first surface, and the antenna is to receive or transmit a signal having a wavelength, forming an ESD path between the antenna and a ground terminal, wherein an electrical length of the ESD path is approximately equal to a fourth of the wavelength, and forming a signal path between the antenna and the IC die, wherein the signal path includes a capacitor, and the substrate includes at least a portion of the capacitor.

In one or more seventeenth embodiments, further to the sixteenth embodiments, the method also includes coupling the antenna to, or forming the antenna on, the second surface.

In one or more eighteenth embodiments, further to the sixteenth or seventeenth embodiments, coupling the IC die to the first surface includes direct bonding the IC die and the substrate.

In one or more nineteenth embodiments, further to the sixteenth through eighteenth embodiments, coupling the IC die to the first surface includes forming the capacitor.

In one or more twentieth embodiments, further to the sixteenth through nineteenth embodiments, forming the ESD path includes forming a via through the substrate.

The disclosure can be practiced with modification and alteration, and the scope of the appended claims is not limited to the embodiments so described. For example, the above embodiments may include specific combinations of features. However, the above embodiments are not limiting in this regard and, in various implementations, the above embodiments may include the undertaking only a subset of such features, undertaking a different order of such features, undertaking a different combination of such features, and/or undertaking additional features than those features explicitly listed. The scope of the patent rights should, therefore, be determined with reference to the appended claims, along with the full scope of equivalents to which such claims are entitled.

## Claims

1. An apparatus, comprising:
a substrate comprising a layer of glass or silicon, the substrate comprising first and second vias spanning between first and second surfaces of the substrate;
an antenna on the first surface, wherein the antenna is coupled to the first and second vias; and
an integrated circuit (IC) die adjacent the second surface, the IC die comprising a first trace or pad coupled to the first via and to ground, the IC die also comprising a second trace or pad capacitively coupled to the antenna through the second via.

2. The apparatus of claim 1, wherein the antenna is coupled to ground by a path comprising the first via, and the path comprises a portion of the IC die.

3. The apparatus of claim 1 or 2, wherein the antenna is coupled to ground by a path comprising the first via, and the path has a length of less than 3 mm.

4. The apparatus of claim 1, 2 or 3, wherein the antenna is to receive or transmit a signal, the signal has a wavelength, the antenna is coupled to ground by a path comprising the first via, and the path has an electrical length approximately equal to a quarter of the wavelength.

5. The apparatus of claim 4, wherein the path has an electrical length greater than 23% of the wavelength and less than 27% of the wavelength.

6. The apparatus of any one of claims 1-5, wherein the second trace or pad is capacitively coupled to the second via by a capacitor comprising first and second electrodes, the substrate comprises the first electrode, and the IC die comprises the second electrode.

7. The apparatus of any one of claims 1-6, wherein the substrate comprises a glass layer, and the first and second vias extend through the glass layer.

8. The apparatus of any one of claims 1-7, wherein the substrate has a thickness of less than 500 µm.

9. The apparatus of any one of claims 1-8, wherein the substrate and the IC die are direct bonded together.

10. The apparatus of any one of claims 1-9, wherein the IC die is coupled to a power supply through a host component, and the IC die is between the substrate and the host component.

11. The apparatus of any one of claims 1-10, wherein a package dielectric is around the IC die and the substrate.

12. A method, comprising:
receiving a workpiece comprising a substrate;
coupling an integrated circuit (IC) die to an antenna by coupling the IC die to a first surface of the substrate, wherein the antenna is on a second surface of the substrate, the second surface distal the first surface, and the antenna is to receive or transmit a signal having a wavelength;
forming an electrostatic discharge (ESD) path between the antenna and a ground terminal, wherein an electrical length of the ESD path is approximately equal to a fourth of the wavelength; and
forming a signal path between the antenna and the IC die, wherein the signal path comprises a capacitor, and the substrate comprises at least a portion of the capacitor.

13. The method of claim 12, further comprising coupling the antenna to, or forming the antenna on, the second surface.

14. The method of either claim 12 or 13, wherein coupling the IC die to the first surface comprises direct bonding the IC die and the substrate.

15. The method of any one of claims 12-14, wherein coupling the IC die to the first surface comprises forming the capacitor.
